# EUROPEAN PATENT APPLICATION

(11) **EP 1 182 282 A1**
(43) Date of publication of application: **27.02.2002**
(21) Application number: 00909745.2
(22) Date of filing: 17.03.2000
(51) Int. Cl.: C30B 29/40

(54) **METHOD OF CRYSTAL GROWTH, METHOD OF FORMING FINE SEMICONDUCTOR STRUCTURE, SEMICONDUCTOR DEVICE, AND SYSTEM**

(30) Priority: 18.03.1999 JP 7288699
(71) Applicant: SHARP KABUSHIKI KAISHA, Osaka 545-8522 (JP)
(72) Inventor: TAKAHASHI, Koji, Tenri-shi, Nara 632-0004 (JP); TOMOMURA, Yoshitaka, Nara-shi, Nara 630-8044 (JP); KAWANISHI, Hidenori, Nara-shi, Nara 631-0804 (JP)
(74) Representative: Hoffmann, Jörg Peter, Dr. Ing.
(86) International application number: JP0001688
(87) International publication number: WO0055398

(57) **Abstract**

A crystal growth method includes a method for adding or crystallizing nitrogen in a crystal, wherein ammonium (NH₃) is used as a nitrogen source material, and aluminum is added.

## Description

### TECHNICAL FIELD

The present invention relates to a method for growing a crystal of a semiconductor material in which nitrogen is added to a crystal or nitrogen is crystallized into a mixed crystal, and to a structure of a semiconductor device using a semiconductor material in which nitrogen is added to a crystal or nitrogen is crystallized into a mixed crystal. Furthermore, the present invention relates to a system using such a semiconductor device.

### BACKGROUND ART

In recent years, a III-V compound mixed crystal semiconductor material including a V group element other than nitrogen (arsenic, phosphorus, antimony, etc.) and several percentages of nitrogen, both of which are included therein as V group compositions, has been proposed as a new material system which significantly enlarges the applicable field of a III-V compound semiconductor. Nitrogen and V group elements other than nitrogen, such as arsenic, phosphorus, antimony, etc., are widely different in atomic radius (nitrogen: 0.070nm, arsenic:0.118nm, phosphorus:0.110nm, antimony:0.136nm) and electronegativity (nitrogen: 3.5, arsenic:2.4, phosphorus:2.5, antimony:2.1). Thus, unique physical properties are obtained by crystallizing nitrogen and a V group element other than nitrogen into a mixed crystal.

For example, in the case of GaInNAs (nitrogen composition: several percentages) which is a mixed crystal formed from GaInAs and several percentages of GaInN which has an energy bandgap larger than that of GaInAs, since bowing of change of the energy bandgap caused by the crystallization into a mixed crystal is very large, the energy bandgap abruptly becomes narrow even if several percentages of a component having a large energy bandgap is crystallized into the mixed crystal. GaInNAs obtained in such a way can be used for an emission layer of a light emitting device which lattice-matches with a low-cost, high-quality GaAs substrate and which emits light at 1.3µm, 1.55µm, or longer wavelength which is important for optical fiber transmission. This material is industrially significant.

The above discussions are specifically described in Japanese Laid-Open Publication No. 6-37355 (first conventional example), PHOTONICS TECHNOLOGY LETTERS, VOL.10, NO.4, APRIL 1998, Page.487 (second conventional example).

In the first conventional example, a mixed crystal of Ga_{1-y}In_{y}N_{z}As_{1-z} (z: -0.04) system is proposed as a new semiconductor material which lattice-matches with a GaAs substrate. It is disclosed that a semiconductor laser which operates within a long wavelength band (1.3-1.55 µm) can be formed on a GaAs substrate, which is conventionally impossible.

In the second conventional example, in a semiconductor laser structure formed on a GaAs substrate, an active layer is formed from a quantum well layer of Ga_{0.7}In_{0.3}N_{0.01}As_{0.99} and a guiding layer of GaAs, and the active layer is sandwiched by upper and lower cladding layers of Al_{0.3}Ga_{0.7}As. It is reported for the first time for a semiconductor laser constructed of a material system which lattice-matches with the GaAs substrate that a room-temperature continuous-wave operation at a wavelength of 1.31 µm was achieved.

The reason that such a III-V compound semiconductor material including both nitrogen and a V group element other than nitrogen was not frequently employed until the recent years resides in the difficulty of growing a crystal. A mixed crystal system of nitrogen and a V group element other than nitrogen (arsenic, phosphorus, antimony, etc.) includes a very large immiscible region (miscibility gap). Thus, in a thermally equilibrium state, a stable mixed crystal cannot be produced. Therefore, as a crystal growth method, molecular beam epitaxial (MBE) growth method or a metal organic chemical vapor deposition (MO-CVD) method which accelerates a crystal growth in a non-equilibrium state is used. Furthermore, a crystal with high quality is produced at a relatively low temperature of 500-600°C as a crystal growth temperature for a III-V compound semiconductor containing nitrogen in its composition. In general, a crystal of nitride semiconductor material only containing nitrogen as a V group element, such as GaN, is produced with high quality at a high temperature in the vicinity of 1000°C. As compared with such a high temperature, the above temperature for crystallizing a material system containing nitrogen, even though the content thereof is very small, is a very low growth temperature.

Since such a material system containing nitrogen can be formed at a relatively low temperature range, as a nitrogen source, an organic compound containing nitrogen, such as dimethylhydrazine (DMeHy), monomethylhydrazine (MMeHy), etc., or nitrogen gas (N₂) previously dissolved and activated by forming plasma have been employed.

Jpn. J. Appl. Phys. Vol.36, No.12A, Dec 1997, page.L1572 (third conventional example) describes an example where a GaAsN crystal is formed by a MO-MBE method by using MMeHy as a nitrogen source at a substrate temperature of 500 °C. A GaInNAs crystal serving as an active layer, which was described in the second conventional example, is formed by a MBE method by using N₂ in the form of plasma as a nitrogen source at a substrate temperature of 500 °C.

In the case where such a novel compound semiconductor is used as an active layer of a semiconductor laser, such as the above-described semiconductor laser example including GaInNAs as an active layer, a superior emission characteristic cannot always be obtained as compared with an equivalent structure including as an active layer a compound semiconductor where nitrogen is crystallized into a mixed crystal. For example, the document which describes the above second conventional example reported that, in a semiconductor laser where GaInAs in which nitrogen is not crystallized into a mixed crystal is used as an active layer (quantum well) and a semiconductor laser where GaInNAs in which nitrogen is crystallized into a mixed crystal is used as an active layer which were formed so as to have a same structure, when 1% of nitrogen was crystallized into a mixed crystal, the oscillation threshold current was increased by about four times while the emission efficiency was decreased to about two thirds; on the other hand, the emission efficiency of the material where a very small amount of nitrogen is crystallized into a mixed crystal was significantly decreased.

One of the reasons for such results is that the crystallinity of a crystal formed by a conventional crystal growth method is not sufficiently superior. Specifically, in the case where an organic compound containing nitrogen, such as dimethylhydrazine (DMeHy), monomethylhydrazine (MMeHy), etc., is employed as a nitrogen source, carbon impurities of a high concentration equal to or greater than 1×10¹⁸cm⁻³ which are derived from an alkyl group are introduced into a crystal. Furthermore, impurity such as moisture is readily introduced into these source materials themselves, and therefore, such materials cannot be industrially produced so as to have a very high purity. The emission rate of such materials of a low purity is low. Therefore, when this material is used as an active layer of a semiconductor laser, the oscillation threshold current is significantly increased. Furthermore, in the case where N₂ in the form of plasma is used as a nitrogen source, a defect due to the plasma is caused to a crystal, and accordingly, the defect density is increased. As a result, the emission efficiency is decreased.

On the other hand, it is expected that, when ammonia (NH₃) gas, which is used as a nitrogen source for the MO-CVD growth of GaN and which can be industrially produced so as to have a high purity, is used as a nitrogen source for crystal growth of a III-V compound mixed crystal semiconductor material where nitrogen and a V group element other than nitrogen in the form of a mixed crystal are crystallized into a mixed crystal, problems such as introduction of carbon impurities and a defect caused by plasma can be avoided. However, NH₃ is a thermally stable molecule and is difficult to thermally decompose at a temperature range from 500°C to 600°C which is suitable for growing a III-V compound mixed crystal semiconductor material including nitrogen and a V group element other than nitrogen, and therefore, the efficiency of use of the material is significantly low. In the case of a MBE method which grows a crystal in a ultra-high vacuum, introducing a gas source whose efficiency of use is very low significantly deteriorates the back pressure of a vacuum chamber and therefore is not preferable.

Furthermore, as a result of the research of the present inventors, when a surface of a substrate of GaAs, GaP, GaSb, or the like, is irradiated with NH₃ gas, the efficiency of surface decomposition of NH₃ and the efficiency of surface adsorption of nitrogen are significantly decreased as compared with a case where a surface of a nitride, such as GaN, is irradiated with NH₃ gas. More specifically, in the case where a crystal of GaN is simultaneously grown on a GaN substrate and a GaAs substrate by using NH₃ as a nitrogen source at a substrate temperature of about 700°C or more at which the efficiency of thermal decomposition of NH₃ is increased, the thickness of crystal growth found on the GaN substrate was ten times larger than that found on the GaAs substrate. This is because the surface activity against NH₃ gas on a surface of a nitride compound (GaN, InN, ...) where the V group component is nitrogen is different from that on a surface of a compound (GaAs, GaP, GaSb, ...) where the V group component is an element other than nitrogen. As a result, it was found that, when a crystal growth is performed on a crystal of a compound different from a nitride compound by using NH₃ gas as a source material, it is necessary to carefully consider the surface activity of the underlying crystal. When forming a crystal containing only several percentages of nitrogen, such as the above-described GaInNAs, the efficiency of use of the material is further decreased because the surface activity against NH₃ gas is low.

An objective of the present invention is to solve the above problems. That is, the present invention provides a crystal growth method capable of growing a crystal while keeping the efficiency of use of a nitrogen material high in the crystal growth process of a material where about several percentages of nitrogen is crystallized in a mixed crystal, for example, a III-V compound mixed crystal semiconductor material where nitrogen and a V group element other than nitrogen are crystallized, such as the above-described GaInNAs. Furthermore, the crystal growth method of the present invention can form a crystal having a high purity, a low defect density, and a superior emission characteristic. The crystal growth method of the present invention is an effective means especially when the crystal growth temperature is relatively low or when the surface activity of the underlying crystal on which a crystal is to be grown is low. Furthermore, the present invention provides a compound semiconductor device having a superior characteristic.

Further still, the present invention includes a technique which is also applicable when it is necessary to add a very small amount of nitrogen into a material, not only when performing crystal growth of a III-V compound semiconductor including nitrogen and an element other than nitrogen as V group elements.

### DISCLOSURE OF INVENTION

A crystal growth method according to the present invention is a method for adding or crystallizing nitrogen in a crystal, wherein ammonium (NH₃) is used as a nitrogen source material, and aluminum is added, whereby the above objective can be achieved.

A crystal growth method according to the present invention is a method for adsorbing a nitrogen atom on a crystal surface, wherein ammonium (NH₃) is used as a nitrogen source material, and the crystal surface includes aluminum, whereby the above objective can be achieved.

A crystal growth method according to the present invention is a method for substituting a portion of elements in a crystal surface with nitrogen atoms, wherein ammonium (NH₃) is used as a nitrogen source material, and the crystal surface includes aluminum, whereby the above objective can be achieved.

Decomposition of ammonium and adsorption of nitrogen on a crystal surface may be accelerated by aluminum.

The aluminum may exist at least in an outermost surface of a growing layer.

An amount of nitrogen added to a crystal, a nitrogen composition, an amount of nitrogen adsorbed on a crystal surface and an amount of an element in the crystal surface which is substituted with a nitrogen atom may be controlled based on an amount or composition ratio of added aluminum.

Aluminum may be added to or crystallized in a restricted region, whereby only in the restricted region, nitrogen is added or crystallized, a nitrogen atom is adsorbed, or an element in a crystal surface is substituted with a nitrogen atom.

A method selected among a molecular beam epitaxial (MBE) growth method, a metal organic molecular beam epitaxial (MO-MBE) growth method, a gas source molecular beam epitaxial (GS-MBE) growth method, and a chemical beam epitaxial (CBE) growth method may be used.

Crystal growth of a III-V compound semiconductor including, as V group components, nitrogen and a V group element other than nitrogen may be performed.

At least one of arsenic (As), phosphorus (P), and antimony (Sb) may be selected as the V group element other than nitrogen.

The substrate temperature may be in a range from 450°C to 640°C.

A series of steps including at least steps of: supplying a III group source material including aluminum of less than one atomic layer; subsequently, supplying ammonium so as to adsorb nitrogen atoms of less than one atomic layer; and supplying a source material of a V group element other than nitrogen may be included, wherein the series of steps may be repeated one time or more.

In the step of supplying ammonium so as to adsorb nitrogen of less than one atomic layer, the source material of the V group element other than nitrogen may not be supplied at the same time.

Crystal growth may be performed over a single crystal substrate in which a {100} surface is a principal plane.

A series of steps including at least steps of: forming a III-V compound crystal layer including at least one molecular layer of aluminum; and subsequently, supplying ammonium so as to substitute a portion of V group atoms in the III-V compound crystal layer with nitrogen atoms may be included, wherein the series of steps may be repeated one time or more.

At least steps of: crystal-forming a layered structure including at least a first semiconductor layer containing aluminum and a second semiconductor layer superposed thereon; etching the layered structure while masking a portion of the layered structure such that the first semiconductor layer is exposed in a portion of an etched surface; and supplying ammonium to the etched surface while heating the layered structure such that at least a portion of a constituent element in the first semiconductor layer is substituted with nitrogen may be included.

The etched surface may be a (n11)A surface (n=1, 2, 3,...).

In a method for forming a semiconductor microwire structure according to the present invention, the crystal growth method according to the present invention is used when forming a semiconductor microstructure having a periodically-positioned wire pattern; a diffraction grating is formed by the step of etching the layered structure while masking a portion of the layered structure such that the first semiconductor layer is exposed in a portion of an etched surface; and a periodical wire structure is formed at a 1/2 of the pitch of the diffraction grating by the step of supplying ammonium to the etched surface while heating the layered structure such that at least a portion of a constituent element in the first semiconductor layer is substituted with nitrogen, whereby the above objective is achieved.

The wire structure may be an absorptive diffraction grating section of a gain-coupled distributed feedback semiconductor laser having an absorptive diffraction grating, or a quantum wire.

A semiconductor device according to the present invention includes a semiconductor layer formed by a crystal growth method according to the present invention, whereby the above objective is achieved.

The semiconductor device may be a light emitting element, and the semiconductor layer may form a light emitting layer thereof.

A surface of the single crystal substrate may be a crystal surface slanted from a (100) surface in a [011] direction (A direction) or a crystal face which is equivalent in a crystallographic sense to the slanted crystal surface.

The slant angle may be within a range equal to 2° or more and equal to 25° or less.

One or more pairs of semiconductor layer A and semiconductor layer B may be superposed, the semiconductor layer A including at least Al and nitrogen in its composition but not including indium in its composition, and the semiconductor layer B including at least indium in its composition but not including nitrogen in its composition.

The thickness of each of the semiconductor layers A and B is one molecular layer or more, and ten molecular layers or less.

A semiconductor device according to the present invention includes a semiconductor layer formed by the crystal growth method according to the present invention, whereby the above objective is achieved.

The semiconductor device may be a light emitting element, and the semiconductor layer may form a light emitting layer thereof.

A system according to the present invention uses a compound semiconductor device according to the present invention, whereby the above objective is achieved.

Hereinafter, functions of the present invention are described.

A crystal growth method of the present invention is a method for adding nitrogen in a crystal or crystallizing nitrogen into a mixed crystal. In the crystal growth method, ammonium (NH₃) is used as a nitrogen source material, and aluminum is added. Further, the present invention relates to a method for adsorbing nitrogen atoms on a crystal surface. In this method, ammonium (NH₃) is used as a nitrogen source material, and the crystal surface includes aluminum. Furthermore, the crystal growth method of the present invention is a method for substituting some of the elements on the crystal surface with nitrogen atoms. In this method, ammonium (NH₃) is used as a nitrogen source material, and the crystal surface includes aluminum.

In this case, by a function of aluminum, the decomposition of ammonium and adsorption on the surface are accelerated, and the introduction efficiency of nitrogen into a crystal is improved. Thus, even in a temperature range where thermal decomposition of ammonium is not sufficient, and even in a substrate surface where the surface activity against ammonium is low, the efficiency of use of ammonium is remarkably improved. Furthermore, problems in a conventional method, such as introduction of carbon impurities and damage caused by plasma, can be avoided, and as a result, a high-quality crystal with a superior emission characteristic is obtained.

Furthermore, in the present invention, a high-quality crystal with a superior emission characteristic is applied to a device, especially to a light emitting device. Thus, the device characteristics, especially emission characteristic, are considerably improved, and the lifetime of the device is considerably increased. Furthermore, an application system which consumes a small amount of electric power can be constructed.

### BRIEF DESCRIPTION OF DRAWINGS

Figure **1** shows a structure of a cross-section of a layered structure produced in examples 1-6 of the present invention and in comparative examples 1-5.
Figure **2** shows an X-ray diffraction chart of the layered structure produced in example 1 of the present invention (where ω-scanning is performed while 2θ is fixed at GaAs (400) position).
Figure **3** shows a correlation between the amount of added aluminum (aluminum composition) and the amount of introduced nitrogen (nitrogen composition) in a layered structure produced in examples 1-4 of the present invention and in comparative example 1.
Figure **4** shows a correlation between the substrate temperature and the amount of introduced nitrogen (nitrogen composition) in a layered structure produced in examples 2, 5, and 6 of the present invention and in comparative examples 4 and 5.
Figure **5** shows a structure of a semiconductor laser produced in example 11 of the present invention and in comparative examples 6-8, which is a cross-sectional view seen from a laser light emission end face.
Figure **6** shows a combination condition between the Al composition and the N composition and a combination condition between the Al composition and the In composition for maintaining the oscillation wavelength at 1.3 µm and the amount of stain at +2% regarding the composition of a AlGaInNAs quantum well active layer of a semiconductor laser produced in example 11 of the present invention and in comparative examples 6-8.
Figure **7** shows a MBE apparatus used in example 12 of the present invention. Part **(a)** is a schematic cross-sectional view seen from a side face direction of the MBE apparatus. Part **(b)** is a plan view of a shutter plate 33.
Figure **8** illustrates a production process of an optical waveguide in example 12 of the present invention. The optical waveguide is produced in the order of (a), (b), and (c).
Figure **9** shows one cycle of a source material supply sequence for crystal growth in examples 13-15 and in comparative example 9.
Figure **10** shows a correlation between the nitrogen composition in a crystal formed in examples 13-15 of the present invention and the duration of ammonium supply at step B.
Figure **11** shows one cycle of a source material supply sequence for crystal growth in example 25 of the present invention.
Figure **12** shows one cycle of a source material supply sequence for crystal growth in example 27 of the present invention.
Figure **13** shows one cycle of a source material supply sequence for crystal growth in example 28 of the present invention.
Figure **14** is a perspective view showing a structure of a semiconductor laser produced in example 29 of the present invention where a portion of the structure is removed for the purpose of illustrating the internal structure thereof.
Figure **15** is a process drawing showing a production process of a diffraction grating section in example 29 of the present invention.
Figure **16** shows a variation of an energy bandgap when some arsenic atoms are substituted with nitrogen atoms in AlGaInAs which is a material of a buried layer in the diffraction grating section in example 29 of the present invention.
Figure **17** is a process drawing showing a production process of a conventional absorptive diffraction grating section.
Figure **18** is a side view showing a structure of a semiconductor laser produced in example 30 of the present invention, which shows a cross-section of the inside of an optical cavity for the purpose of illustrating the internal structure.
Figure **19** is a process drawing showing a production process of a quantum wire section in example 30 of the present invention.
Figure **20** shows a dependency of the nitrogen composition z in a well layer formed in example 31 and in comparative examples 11 and 12 on the slant angle of the substrate. In the drawing, a plot of solid circles which is indicated by "H" is a plot of example 31 and comparative example 11, and a plot of open squares which is indicated by "K" is a plot of comparative example 12.
Figure **21** shows a dependency of the photoluminescence emission intensity in a single well layer formed in example 31 and in comparative examples 11 and 12 on the slant angle of the substrate. In the drawing, a plot of solid circles which is indicated by "H" is a plot of example 31 and comparative example 11, and a plot of open squares which is indicated by "K" is a plot of comparative example 12.
Figure **22** shows an optical transmission/reception module produced in example 33.

### BEST MODE FOR CARRYING OUT THE INVENTION

In examples 1-4 and comparative examples 1-3, a method for crystallizing nitrogen into a mixed crystal containing aluminum in its composition by using ammonium (NH₃) as a nitrogen source so as to obtain a mixed crystal is described by illustrating specific examples.

### (Example 1)

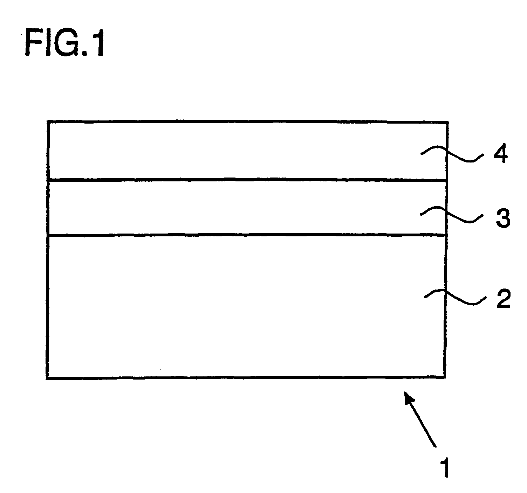

A layered structure 1 shown in Figure 1 was formed by a MBE (molecular beam epitaxy) method using a NH₃ gas source as a nitrogen source. In this structure, a layered structure includes an AlGaAs layer **3** of 1.4 µm and an AlGaAsN layer **4** of 1.4 µm on a GaAs (100) substrate **2**.

In the MBE method, as source for materials other than nitrogen, i.e., Al, Ga, As, solid sources of Al metal, Ga metal, and As metal were used. Further, the beam pressures for Al, Ga, As₄ during crystal growth which were measured with a nude ion gauge provided at a position of the substrate were 2.7×10⁻⁷ torr, 4.0×10⁻⁷ torr, 1.0× 10⁻⁵ torr, respectively. The feed rate of NH₃ was 5 cc/min, and the beam pressure was 3.9×10⁻⁶ torr. The AlGaAs layer 3 and the AlGaAsN layer **4** were formed under the same beam condition for Al, Ga, and As₄. A NH₃ beam was added only during growth of the AlGaAsN layer **4.** The substrate temperature during the crystal growth was 550°C. Furthermore, in this case, the growth rate was 1.4 µm/hr.

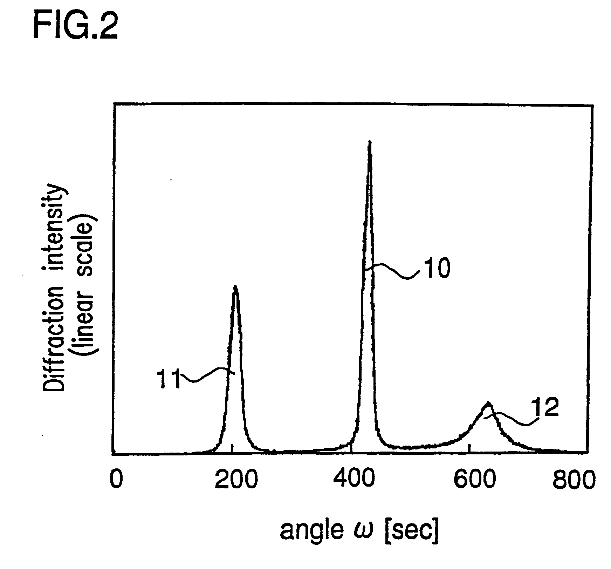

In the formed layered structure 1, the lattice constant of each layer was measured by a double crystal X-ray diffraction method so as to obtain a nitrogen composition. Figure **2** is an X-ray diffraction of the formed layered structure. The measurement was carried out by a ω scan method while 2θ was fixed at the Bragg angle of GaAs (400). A peak **10** is a diffraction from a (400) face of the GaAs substrate, a peak 11 is a diffraction from a (400) face of the AlGaAs layer **3**, and a peak **12** is a diffraction from a (400) face of the AlGaAsN layer **4**.

From this result, it was found that the layer **4** contains nitrogen crystallized in a mixed crystal, and a superior single crystal film having a lattice constant smaller than that of the GaAs substrate and the layer **3** was obtained therein. It was also found from the difference in the diffraction angle between the peak **10** and the peak **11** that the Al composition in the layer **3** was 60%. Furthermore, the nitrogen composition in layer **4** was calculated from the difference in the diffraction angle between the peak **11** and the peak **12** under the assumption that the Al composition is the same in the layer **3** and the layer **4**. As a result, it was found that nitrogen was crystallized in a mixed crystal at a composition of 1.5%. Furthermore, the nitrogen composition in the layer **4** accorded to a result of the measurement by a SIMS method.

### (Examples 2-4)

Samples which have the same structure as that shown in Figure **1** except that the Al composition in the AlGaAs layer **3** and the AlGaAsN layer **4** is 10% (example 2), 30% (example 3), and 100% (example 4) were formed. Herein, in order to form samples having a different Al composition while the growth rate was kept equal to that of example 1 (1.4 µm/hr), the Al beam pressure and the Ga beam pressure for forming each sample were suitably adjusted. Specifically, in example 2, the Al beam pressure was set to 4.6×10⁻⁸ torr, the Ga beam pressure was set to 8.1×10⁻⁷ torr. In example 3, the Al beam pressure was set to 1.4×10⁻⁷ torr, the Ga beam pressure was set to 6.3×10⁻⁷ torr. In example 4, the Al beam pressure was set to 4.5×10⁻⁷ torr.

The other growth conditions, such as the feed rate of NH₃ and As₄, the growth temperature, etc., are the same as those of example 1.

The nitrogen composition in the samples formed in such a way were measured by the same method as that used in example 1 including the double crystal X-ray diffraction method. The nitrogen composition in example 1, example 2, and example 3 were 0.3%, 0.7%, and 2.5%, respectively.

### (Comparative Example 1)

A sample which has the same structure as that shown in Figure **1** except that the Al composition in the AlGaAs layer **3** and AlGaAsN layer **4** is 0% was formed under the same growth conditions of, such as, the feed rate of NH₃ and As₄, the growth temperature, etc. That is, the AlGaAs layer **3** is GaAs, and the layer **4** is GaAsN.

The nitrogen composition in the sample formed in such a way was measured by the same method as that used in example 1 including the double crystal X-ray diffraction method. In the X-ray diffraction, it was not found that nitrogen was crystallized in a mixed crystal as a component thereof. The nitride concentration in the layer **4** measured by a SIMS method was 2.2×10¹⁷ cm⁻³ (0.001% in composition). Thus, it was found that nitrogen cannot be introduced in a crystal to such an amount that influences the lattice constant and the band structure.

### (Comparative Examples 2 and 3)

Samples having the same structure as that shown in Figure **1** and including the GaAs layer **3** and the GaAsN layer **4** which are the same as those included in comparative example 1 were formed by using DMeHy (comparative example 2) and N₂ in the form of plasma (comparative example 3) as a nitrogen source. The flow rate of DMeHy in comparative example 2 was 2 cc/min (the beam pressure at the substrate position was 2.4×10⁻⁶ torr). In comparative example 3, the flow rate of N₂ was 0.3 cc/min, and the plasma power was 200 W.

The nitrogen composition in the samples formed in such a way were measured by the same method as that used in example 1 including the double crystal X-ray diffraction method. The nitrogen composition in example 2 and example 3 were 1.6% and 1.2%, respectively.

Hereinafter, a function and an effect of the present invention are described with reference to examples 1-4 and comparative examples 1-3.

Although all of examples 1-4 and comparative example 1 use NH₃ as a source material in an attempt to crystallize nitrogen into a mixed crystal, however, in examples 1-4, nitrogen introduced into a solid phase is several hundreds to several thousands times larger as compared with comparative example 1. The reason that the nitrogen composition is significantly low in comparative example 1 is that NH₃ is a stable molecule, and the thermal decomposition efficiency or the surface adsorption efficiency of the NH₃ material is significantly low at a substrate temperature of 550 °C. Furthermore, on the surface of GaAsN where the density of nitrogen to be grown is low, the surface activity against NH₃ is significantly low as compared with a surface of a nitride compound. Therefore, the thermal decomposition efficiency or the surface adsorption efficiency of the source material is further decreased. Furthermore, even when the feed rate of NH₃ was increased by 10 times as compared with example 1, the amount of introduced nitrogen was not increased in proportion to the feed rate of NH₃.

On the other hand, in examples 1-4 where Al is added in the layer **4,** nitrogen is crystallized in a mixed crystal on the composition order although NH₃ was supplied on the same conditions as those in comparative example 1. Furthermore, the content of nitrogen linearly increases in proportion to the increase of the Al composition even when the feed rate of NH₃ is the same. This is caused because, when Al exists on the surface of a crystal, NH₃, whose efficiency of use of a source material is low, is subjected to a cracking-catalytic effect of Al, and the decomposition thereof is accelerated into an active state, or a chemical species generated by the decomposition of NH₃ is readily adsorbed on a surface of a growing layer via Al. As a result, the efficiency of use of the NH₃ material is significantly increased on the order of several hundreds to several thousands of times according to the amount of added Al.

That is, when nitrogen is introduced into a crystal by using NH₃ as a nitrogen source, adding Al to the crystal is effective in accelerating the decomposition of NH₃ and the adsorption of nitrogen and significantly increasing the efficiency of use of the source material.

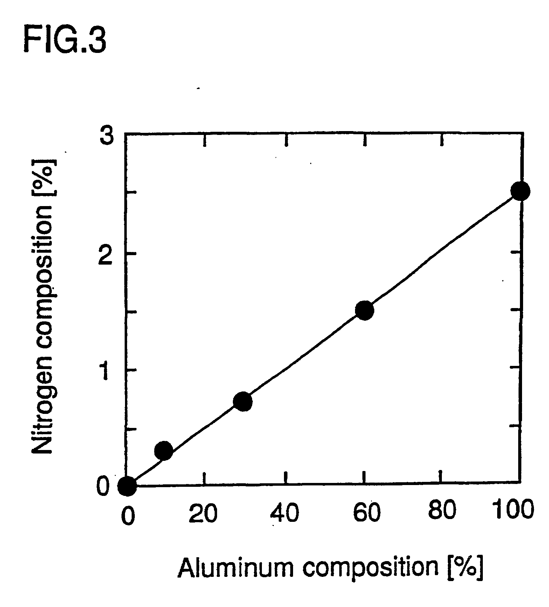

Furthermore, from Figure 3 where the composition of added Al and the composition of introduced N are shown, it is found as to the crystals formed in examples 1-4 that, even when the introduction efficiency of nitrogen is changed according to the amount of added Al and the feed rate of NH₃ is constant, the N composition can be controlled by adjusting the amount of added Al over a wide range from 0.001% to 2.5%.

On the other hand, in example 2 where DMeHy is used as a nitrogen source, the decomposition temperature of the source material is low; and in example 2 where N₂ in the form of plasma is used as a nitrogen source, the source material is previously decomposed/activated. Thus, nitrogen can be crystallized into a mixed crystal without adding Al on the composition order, which cannot be achieved when NH₃ is used. Furthermore, the efficiency of use of the source material is high. However, a result of the measurement of the residual impurity density and the etch pit density in the layer 4 formed in example 1 and comparative examples 2 and 3 by a SIMS method are shown in Table 1.

**[Table 1]**

| | Example 1 | Comparative Example 2 | Comparative Example 3 |
|---|---|---|---|
| Residual carbon impurity concentration | <1×10¹⁶ cm⁻³ (equal to or smaller than SIMS measurement lower limit) | 2×10¹⁸ cm⁻³ | <1×10¹⁶ cm⁻³ (equal to or smaller than SIMS measurement lower limit) |
| Etch bit density | - 2×10³ cm⁻² | - 7×10⁴ cm⁻² | - 6×10⁵ cm⁻² |

That is, when DMeHy is used as a source material, a carbon impurity having a high concentration is mixed into the layer **4,** and thus, only a film having a low purity can be obtained. In the case where radicalized N₂ is used, only a film having a high defect density can be obtained due to damage caused by plasma. With these films, a high gain cannot be expected when it is applied to an active layer of a semiconductor laser. On the other hand, in the case where NH₃ is used as a source material, where surface decomposition/adsorption is accelerated by Al, it is found that a film containing nitrogen and arsenic with a small residual impurity density and a low defect density in a mixed crystal can be obtained, and deterioration of the crystallinity caused by the crystallization of nitrogen into a mixed crystal does not occur.

As described above, when forming a crystal containing nitrogen and a V group element other than nitrogen, NH₃ is used as a nitrogen source, and the decomposition and adsorption of NH₃ are assisted by Al, whereby the efficiency of use of NH₃ is significantly increased. As a result, a crystal with a small residual impurity and a low defect density as compared with a conventional method can be obtained.

The features of the present invention as to a correlation between the amount of added Al and introduction of nitrogen have been described while the substrate temperature is fixed to 550°C in examples 1-4 and comparative example 1. In examples 5 and 6 and comparative examples 4 and 5, the features of the present invention as to the substrate temperature will be described while NH₃ is used as a nitrogen material, and the efficiency of use of NH₃ is improved by Al.

### (Examples 5 and 6)

Samples which have the same structure as that shown in Figure **1** except that the Al composition in the AlGaAs layer **3** and the AlGaAsN layer **4** is 10% as in example 2, and the substrate temperature is set to 640°C (example 5) and 450°C (example 6) were formed. The other growth conditions were the same as those in example 2.

The nitrogen composition in the samples formed in such a way were measured by the same method as that used in example 1 including the double crystal X-ray diffraction method. The nitrogen composition in example 5 and example 6 were 0.9% and 0.2%, respectively. Furthermore, these values accorded to a result of the measurement by a SIMS method.

### (Comparative Examples 4 and 5)

Samples which have the same structure as that shown in Figure **1** except that the Al composition in the AlGaAs layer **3** and the AlGaAsN layer **4** is 10% as in example 2, and the substrate temperature is set to 680°C (comparative example 4) and 400°C (comparative example 5) were formed. The other growth conditions were the same as those in example 2.

Performing a structural analysis on the sample formed in comparative example **4** by an X-ray diffraction method, it was found that the phase of the layer **4** was separated into an AlGaAsN phase and an AlGaN phase.

The nitrogen composition in the sample formed in comparative example 5 was measured by the same method as that used in example 1 including the double crystal X-ray diffraction method. It was not found by the X-ray diffraction that nitrogen is crystallized in a mixed crystal as a component thereof. Measuring the nitrogen content by a SIMS method, the atomic density of nitrogen in the layer **4** was 5×10¹⁷ cm⁻³. Thus, it was found that nitrogen cannot be introduced in a crystal to such an amount that influences the lattice constant and the band structure.

Hereinafter, a function and an effect of the present invention are described with reference to examples 2, 5 and 6 and comparative examples 4 and 5.

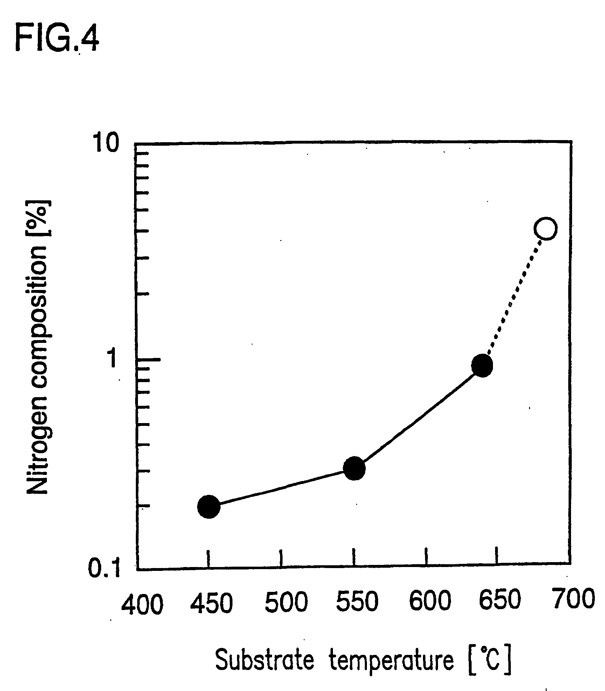

The features of the present invention as to a correlation between the substrate temperature and the nitrogen composition indicated in examples 2, 5 and 6 and comparative example 4 are shown in Figure **4** altogether. It is clear from Figure **4** that introduction of nitrogen deeply depends on the substrate temperature, and that it is possible to crystallize nitrogen into a mixed crystal on the composition order in a temperature substrate range of 450°C or more. This reflects the temperature dependency of a catalytic characteristic of aluminum which functions as a cracking catalyst for NH₃. However, it is understood that the substrate temperature of 680°C or higher is undesirable because a nitride phase of AlGaN or the like, which is readily generated at a high temperature, is mixed and causes phase separation.

In examples 1-6, the features of the present invention are described as to crystal growth of a compound semiconductor containing arsenic and nitrogen as V group elements. In examples 7-10, phosphorus or antimony and nitrogen are contained as V group elements.

### (Example 7)

In this example, NH₃ is used as a nitrogen source to grow on a GaAs substrate a crystal of an Al_{0.05}Ga_{0.43}In_{0.52}P_{0.97}N_{0.03} layer which lattice-matches with the GaAs substrate. For crystal growth, a gas source MBE method is used; Al metal is used as an Al source (beam intensity: 2.5×10⁻⁸ torr); Ga metal is used as a Ga source (beam intensity: 2.2×10⁻⁷ torr); In metal is used as an In source (beam intensity: 2.6×10⁻⁷ torr); and P metal is used as a P source (beam intensity: 5.0×10⁻⁶ torr). Herein, a gas source is only the NH₃ gas (beam intensity: 3.0×10⁻⁶ torr) which is used as a N source. The growth temperature is 550°C. In a crystal layer having a thickness of 1 µm, the lattice constant and the content of each element were measured. Without Al, the decomposition/adsorption efficiency of NH₃ was significantly small, and accordingly, nitrogen was not crystallized into a mixed crystal on the composition order such as to give an influence to the lattice constant and the energy bandgap. On the other hand, when Al is added, the decomposition/adsorption efficiency of NH₃ was increased by about 100 times, and as a result, a mixed crystal containing 3% of nitrogen was formed. The formed crystal did not contain a carbon impurity, had a small etch pit density, and exhibited superior crystallinity.

### (Example 8)

In this example, NH₃ is used as a nitrogen source to grow on an InP substrate a crystal of an Al_{0.05}In_{0.95}As_{0.014}P_{0.961}N_{0.025} layer which lattice-matches with InP. For crystal growth, a gas source MBE method is used; Al metal is used as an Al source (beam intensity: 3.1 × 10⁻⁸ torr); In metal is used as an In source (beam intensity: 5.7×10⁻⁷ torr); AsH₃ gas is used as an As source (beam intensity: 1.5×10⁻⁷ torr); and PH₃ gas is used as a P source (beam intensity: 1.0×10⁻⁵ torr). As a N source, NH₃ gas (beam intensity: 4.0×10⁻⁶ torr) is used. The growth temperature is 550°C. In a crystal layer having a thickness of 1 µm, the lattice constant and the content of each element were measured. Without Al, the decomposition/adsorption efficiency of NH₃ was significantly small, and accordingly, nitrogen was not crystallized into a mixed crystal on the composition order such as to give an influence to the lattice constant and the energy bandgap. On the other hand, when Al is added, the decomposition/adsorption efficiency of NH₃ was increased by about 100 times, and as a result, a mixed crystal containing 2.5% of nitrogen was formed. The formed crystal did not contain a carbon impurity, had a small etch pit density, and exhibited superior crystallinity.

### (Example 9)

In this example, NH₃ is used as a nitrogen source to grow on a Si slanted substrate a crystal of an Al_{0.15}Ga_{0.85}P_{0.978}N_{0.022} layer which lattice-matches with Si. For crystal growth, a gas source MBE method is used; Al metal is used as an Al source (beam intensity: 6.0 × 10⁻⁸ torr); Ga metal is used as a Ga source (beam intensity: 3.4×10⁻⁷ torr); and PH₃ gas is used as a P source (beam intensity: 6.0×10⁻⁶ torr). As a N source, NH₃ gas (beam intensity: 6.0 × 10⁻⁶ torr) is used. The growth temperature is 600°C. In a crystal layer having a thickness of 1 µm, the lattice constant and the content of each element were measured. Without Al, the decomposition/adsorption efficiency of NH₃ was significantly small, and accordingly, nitrogen was not crystallized into a mixed crystal on the composition order such as to give an influence to the lattice constant and the energy bandgap. On the other hand, when Al is added, the decomposition/adsorption efficiency of NH₃ was increased by about 100 times, and as a result, a mixed crystal containing 2.2% of nitrogen was formed. The formed crystal did not contain a carbon impurity, had a small etch pit density, and exhibited superior crystallinity.

### (Example 10)

In this example, NH₃ is used as a nitrogen source to grow on a GaAs substrate a crystal of an Al_{0.3}Ga_{0.7}As_{0.803}Sb_{0.142}N_{0.055} layer which lattice-matches with GaAs. For crystal growth, a gas source MBE method is used; Al metal is used as an Al source (beam intensity: 2.4 ×10⁻⁷ torr); Ga metal is used as a Ga source (beam intensity: 5.6×10⁻⁷ torr); As metal is used as an As source (beam intensity: 1.0×10⁻⁵ torr); and Sb metal is used as a Sb source (beam intensity: 1.8×10⁻⁶ torr). Herein, a gas source is only the NH₃ gas (beam intensity: 8.0× 10⁻⁶ torr) which is used as a N source. The growth temperature was 550°C. In a crystal layer having a thickness of 1 µm, the lattice constant and the content of each element were measured. Without Al, the decomposition/adsorption efficiency of NH₃ was significantly small, and accordingly, nitrogen was not crystallized into a mixed crystal on the composition order such as to give an influence to the lattice constant and the energy bandgap. On the other hand, when Al is added, the decomposition/adsorption efficiency of NH₃ was increased by about 100 times, and as a result, a mixed crystal containing 5.5% of nitrogen was formed. The formed crystal did not contain a carbon impurity, had a small etch pit density, and exhibited superior crystallinity.

In examples 7-10, the decomposition and adsorption of NH₃ are assisted by Al, whereby the efficiency of use of NH₃ is significantly increased. As a result, a crystal with a small residual impurity and a low defect density can be obtained. Such a crystal can be obtained not only when the V group element other than nitrogen is arsenic but also when the V group element other than nitrogen is phosphorus, antimony, or a combination thereof.

Hereinafter, example 11 and comparative examples 6-8 where the crystal growth method described above was used for the production of a light emitting element are described in detail.

### (Example 11)

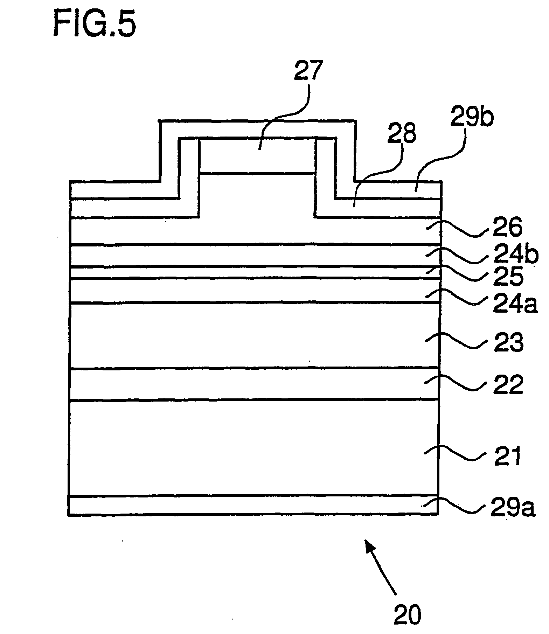

In this example, a semiconductor laser **20** which emits light at a wavelength of 1.3 µm was produced as shown in Figure **5**. The wavelength of 1.3 µm is a wavelength at which the wavelength dispersion of a quartz-based optical fiber is minimum and which is significant in optical transmission with an optical fiber. The semiconductor laser **20** includes a n-type GaAs substrate **21** (300 µm); a n-type GaAs buffer layer **22** (0.5 µm); a n-type Al_{0.4}Ga_{0.6}As lower cladding layer **23** (1 µm) ; an undoped Al_{0.1}Ga_{0.9}As guiding layer **24a** (0.1 µm); an undoped Al_{0.1}Ga_{0.58}In_{0.32}N_{0.019}As_{0.981} well layer **25** (+2% of compressive strain, 6 nm); an undoped Al_{0.1}Ga_{0.9}As guiding layer **24b** (0.1 µm); a p-type Al_{0.4}Ga_{0.6}As upper cladding layer **26** (1 µm); a p⁺-type GaAs contact layer **27** (0.5 µm); a nitride silicon current confinement layer **28**; and a AuGe electrode metal **29a** and a AuZn electrode metal **29b** which sandwich the above layered structure.

The above semiconductor structure was produced by CBE (chemical beam epitaxial growth) method using TMAl (trimethylaluminum), TMGa (trimethylgallium), TMIn (trimethylindium), AsH₃ (arsine), NH₃ (ammonium) as an Al source material, a Ga source material, an In source material, an As source material, and a N source material. The above semiconductor structure can also be produced by a MO-MBE (metalorganic molecular beam epitaxial growth) method where solid arsenic (As₄ or As₂) is used instead as an As source material, a GS-MBE (gas source molecular beam epitaxial growth) method where solid source material is used instead as a III group material, or a MBE method where an As source material and a III group material are solid materials, and only a N source material is a gas material, i.e., NH₃ gas, as in example 1. The conduction type of the cladding layers and the contact layer was controlled by Si-doping using solid Si as a source material when a n-type layer was produced and by Be-doping using solid Be as a source material when a p-type layer was produced. The substrate temperature during crystal growth was 640 °C, and the growth rate was 1 µm/hr. When the Al_{0.1}Ga_{0.58}In_{0.32}N_{0.019}As_{0.981} well layer 25 was formed, the flow rate of NH₃ was set to 5 cc/min. In order to assist the decomposition and adsorption of NH₃, Al is added at a composition of 10%.

The thus-produced semiconductor laser **20** is continuously oscillated at a wavelength of 1.31 µm at room temperature. In this case, the oscillation threshold current was 15 mA in the case of a ridge-type waveguide having a width of 2.5 µm. Further, the characteristic temperature (Tₒ) was 175 K. Furthermore, in the semiconductor laser element, as a result of an aging test at 85°C and 10 mW, no deterioration was found for 10,000 hours or more.

### (Comparative Example 6)

A semiconductor laser having the same structure as that of example 11 was formed by the same method as that used in example 11 except that Al is not added in the well layer **25.** A nitrogen source material was NH₃. In this example, even when the NH₃ material was supplied to the same amount as that used in example 11 during the formation of the well layer **25,** only about 0.002% of nitrogen was crystallized in a mixed crystal. This is because the decomposition/adsorption efficiency of NH₃ was significantly low. The oscillation wavelength of the laser was 1.08 µm.

### (Comparative Examples 7 and 8)

A semiconductor laser having the same structure as that of example 11 was produced using DMeHy (comparative example 7) or N₂ in the form of plasma (comparative example 8) as a nitrogen source by the same method as that used in example 11 except that Al was not added in the well layer **25**. Not as in comparative example 6, nitrogen was crystallized into a mixed crystal without adding Al in the well layer **25.** The produced semiconductor laser was continuously oscillated at a wavelength of 1.31 µm at room temperature by adjusting the composition of the well layer **25** to Ga_{0.7}In_{0.3}N_{0.01}As_{0.99}. In this case, in the case of a ridge-type waveguide having a width of 2.5 µm, the oscillation threshold current was 37 mA in comparative example 7 and 32 mA in comparative example 8. Further, the characteristic temperature (Tₒ) was 85 K in comparative example 7 and 90 K in comparative example 8. Furthermore, in the semiconductor laser element, as a result of an aging test at 85°C and 10 mW, both in comparative examples 7 and 8, the operation current is increased by 20% or more at about 500 hours, a significant deterioration was found.

Hereinafter, a function and an effect of the present invention are described with reference to example 11 and comparative examples 6-8.

Both in example 11 and comparative example 6, NH₃ is used as a nitrogen source for forming the quantum well layer **25**. However, in comparative example 6 where Al is not added, a sufficient amount of nitrogen was not crystallized in a mixed crystal. In this case, the nitrogen composition is about 0.002% (atomic density: 4.4 × 10¹⁷ cm⁻³). At this level, influence on the band structure and the lattice constant is substantially nothing. Even when the feed rate of NH₃ is increased so as to be 10 times larger than that in comparative example 6, the amount of nitrogen introduced was not increased in proportion to the feed rate of NH₃, and exhibited a tendency to saturate.

In order to achieve a laser oscillation at a wavelength of 1.3 µm which is important in optical transmission using an optical fiber, it is necessary to narrow the energy bandgap by increasing the nitrogen composition to about 1-2%. However, such a crystal cannot be formed only by using NH₃ as a nitrogen source. On the other hand, in example 11 where Al of a low composition is added, even if the feed rate of NH₃ is the same as that when Al is not added, about 1000 times larger an amount of nitrogen is crystallized in a mixed crystal. As in example 1, this is because addition of Al accelerates the decomposition of NH₃ and the adsorption of nitrogen and significantly increases the efficiency of use of the source material. The present invention is the first one that can produce an active layer with a superior crystallinity which emits light at a wavelength of 1.3 µm.

On the other hand, in comparative example 7 using DMeHy which can be decomposed at a low temperature, and in comparative example **8** using radicalized N₂, laser oscillation at a wavelength of 1.3 µm can be achieved by crystallizing nitrogen in a mixed crystal. However, a large amount of carbon residual impurities exists in the well layer **25** (comparative example 7) or numerous crystal defects are formed due to damage caused by plasma (comparative example 8), and accordingly, a laser element which has a sufficient optical gain and deterioration resistance as compared with example 11 cannot be obtained.

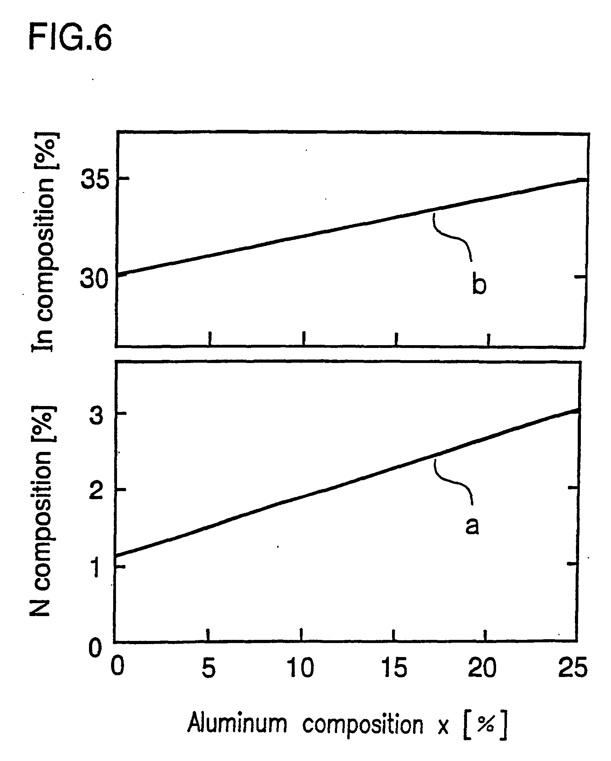

When Al is crystallized in a mixed crystal in the active layer (well layer **25**), the energy bandgap is expanded along with the crystallization of Al into a mixed crystal, and accordingly, the oscillation wavelength becomes short. In example 11, the compositions of nitrogen and indium are adjusted such that the expansion of the energy bandgap along with the crystallization of Al into a mixed crystal is cancelled, and the lattice constant does not change. Figure **6** shows a relationship between the Al composition and the nitrogen composition for obtaining a wavelength of 1.3 µm and the indium composition. In this case, the amount of compressive strain in the well layer is kept at 2%. In the case of example 11 where the Al composition is 10%, the oscillation wavelength may be kept the same by increasing the nitrogen composition by about 1.7 times and increasing the indium composition by about 1.07 times as compared with comparative examples 7 and 8 where Al is not crystallized in a mixed crystal. In example 11, a semiconductor laser which emits light at a wavelength of 1.3 µm has been described. However, any wavelength can be selected by adjusting the composition of the active layer according to the application of the semiconductor laser, such as 1.2 µm, 1.55 µm, etc. Furthermore, an edge-emission semiconductor laser having a Fabry-Perot optical cavity has been described, but a distributed feedback semiconductor laser, a distributed Bragg reflector semiconductor laser, a vertical cavity surface emitting laser, an optical amplifier, a light emitting diode, etc., can be produced similarly as described above.

Furthermore, as for the structure of the active layer, a strained quantum well type having compressive strain has been described, but any direction of strain and any amount of strain can be freely selected. Furthermore, the active layer may be any of a bulk active layer, a quantum wire active layer, and a quantum box active layer. The crystal growth method for a semiconductor device structure such as these semiconductor lasers is not limited to a method described in example 11. It is needless to say that methods described in other examples can provide equivalent effects.

In example 12, as an application of the previously-described crystal growth method, a method for selectively crystallizing nitrogen in a specific region, and an application example thereof to a device are described in detail.

### (Example 12)

In this example, an optical waveguide was produced such that a core layer is two-dimensionally buried in a semiconductor by a single crystal growth by utilizing a fact that, when NH₃ is used as a nitrogen source material to form a mixed crystal containing As and N as V group elements, the amount of nitrogen to be introduced into the mixed crystal is changed on the order of 100-1000 times based on whether Al is added or not.

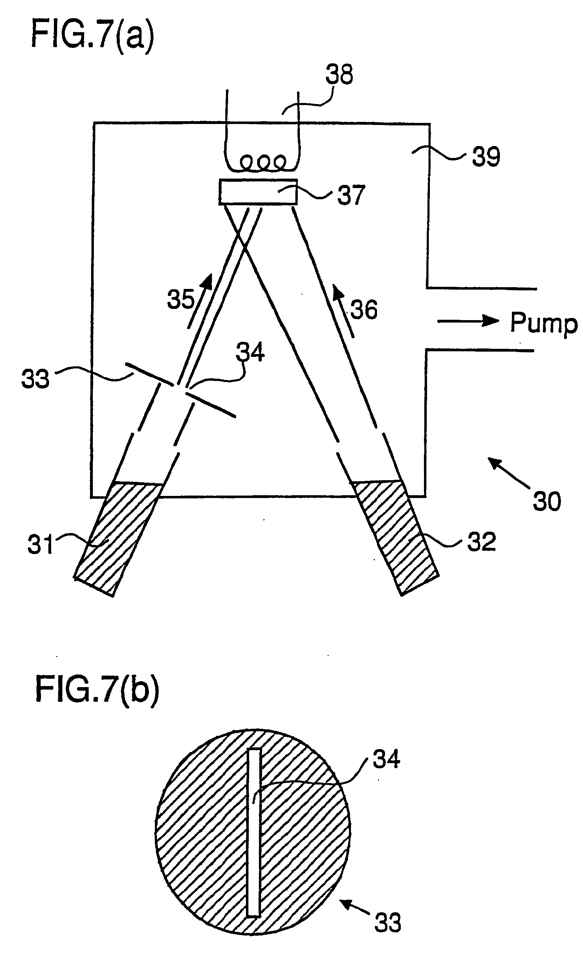

The production method employed is a MBE method which is same as the MBE method used in example 1 in that a solid source is used as a III group material, and a NH₃ gas source is used as a nitrogen source material, but specifically the production method employed is a GS-MBE (gas source MBE) method which is different from the MBE method used in example 1 in that a AsH₃ gas source is used as an As source material. It should be noted that even when solid As is used as in example 1, the same result is obtained. The substrate is a (100) face of GaAs, and the growth temperature is 640°C. The major difference from example 1 is that a shutter plate **33** with a rectangular opening **34** having a width of 20 µm and a length of 1 mm (Figure **7(b)**) which allows only a portion of an Al beam to pass therethrough is provided between a K cell **31** for supplying an Al source material and the GaAs substrate **37**. There is no shutter plate provided for a K cell **32** for supplying source materials other than Al and a gas cell.

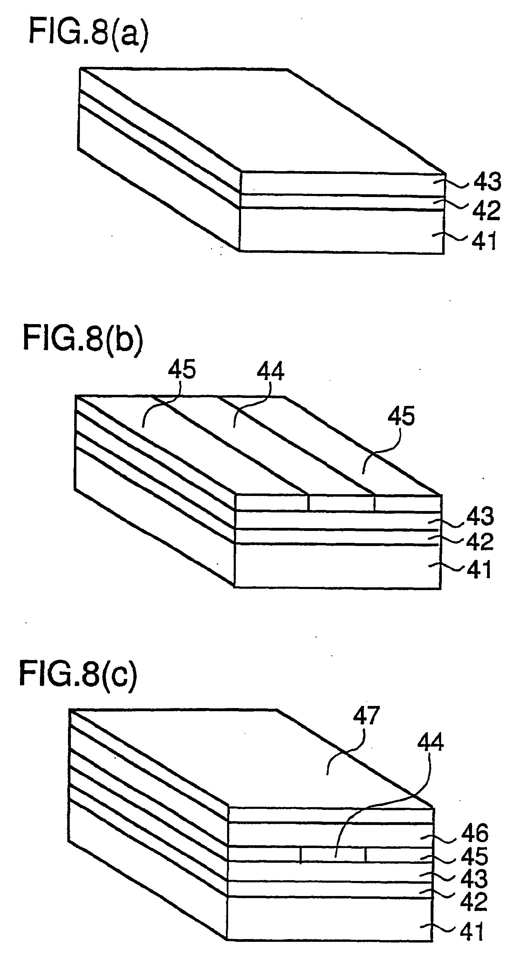

The production process of the optical waveguide is described in a step-by-step manner with reference to a cross-sectional view shown in Figure 8. First, over the entire surface of a semi-insulative GaAs substrate **41**, a GaAs buffer layer **42** of 0.5 µm and a Al_{0.1}Ga_{0.9}As lower cladding layer **43** of 1 µm are formed (Figure **8(a)**). During the formation of the lower cladding layer, the shutter plate **33** is not used such that an Al source material is supplied over the entire surface of the substrate.

Next, a core layer is formed. During the formation of the core layer, an NH₃ beam is supplied, and in the meantime, the shutter plate **33** is placed between the K cell **31** and the substrate **37** while supplying Al. Only a portion of the Al beam which passed through the opening **34** of the shutter plate 33 reaches a growing layer, whereby Al is supplied to a limited, stripe area **44.** Other source materials, Ga, As₄, and NH₃, are emitted over the entire surface of the substrate.

In this step, the decomposition and adsorption of the NH₃ beam emitted over the stripe area **44**, to which Al is supplied, is accelerated, whereby nitrogen is introduced in a composition as a component thereof. On the other hand, in an area **45**, nitrogen is not introduced on the composition order from the NH₃ beam emitted over the area **45** shielded from Al. In this way, the core layer **44** was formed so as to have a thickness of 0.1 µm. The composition of the stripe area **44** was Al_{0.1}Ga_{0.9}As_{0.96}N_{0.04}. On the other hand, the composition of the area **45** which is outside of the stripe was GaAs, in which only about 5×10¹⁷ cm⁻³ of nitrogen is contained.

Next, over the resultant structure, a Al_{0.1}Ga_{0.9}As upper cladding layer **46** of 1 µm and a GaAs cap layer **47** of 0.1 µm are formed over the entire surface of the substrate.

The distribution of refractive index in the produced structure is such that the refractive index increases in the order of the upper and lower cladding layers **43** and **46** (Al_{0.1}Ga_{0.9}As), a lateral confinement layer **45** (GaAs), and the core layer **44** (Al_{0.1}Ga_{0.9}As_{0.96}N_{0.04}). Thus, the core layer having a higher refractive index is buried by the materials having a lower'refractive index. Especially in the case where nitrogen is crystallized into a III-V group mixed crystal containing a V group element other than N in its composition, a physical property that the refractive index sharply increases along with the crystallization of nitrogen into a mixed crystal. Thus, a large refractive index distribution can be obtained by partially crystallizing a very small amount of nitrogen into a mixed crystal. It was observed in the produced optical waveguide that when light at a wavelength of 1.3 µm is supplied from outside to the core layer **44,** the supplied light is two-dimensionally confined in the core layer and efficiently guided through the optical waveguide.

The shape, arrangement, number, and dimensions of the opening **34** of the shutter plate **33** used in example 12 are freely determined. With the opening **34** having any shape, arrangement, number, and dimensions, an AlGaAsN layer was selectively grown. Furthermore, a method equivalent to the above method can produce not only the optical waveguide shown in this example, but also a buried hetero laser, a quantum wire, a three-dimensionally buried quantum dot, etc.

In this example, a shutter plate having an opening is used for supplying Al to only a limited area. However, it is needless to say that an Al supply distribution can be created by any other method. It is only necessary to partially block a molecular beam of Al by any means.

In example 12, a case where Ga is contained as a III group element in addition to Al, and, As and N are contained as V group elements, has been described. However, it is needless to say that even in a mixed crystal system containing any III group element (In, etc.) and/or any V group element (P, Sb, etc.), equivalent function and effect can be produced by supplying Al to a selected area. For example, material systems such as AlGaInNAs, AlGaInPN, AlGaInAsPN, AlGaSbAsN, AlInPAsN, or the like, can be used.

In examples 13-24 and comparative example 9, a method which can increase the amount of introduced nitrogen is described by illustrating specific examples.

### (Example 13)

In this example, a method for forming a AlGaAsN crystal having a larger nitrogen composition and superior crystallinity as compared with examples 1-4 is practiced in the formation of AlGaAsN using NH₃. In this example, the crystal growth method is the MBE method same as used in example 1, and source materials for respective elements, a substrate temperature, a substrate used are the same as those in example 1.

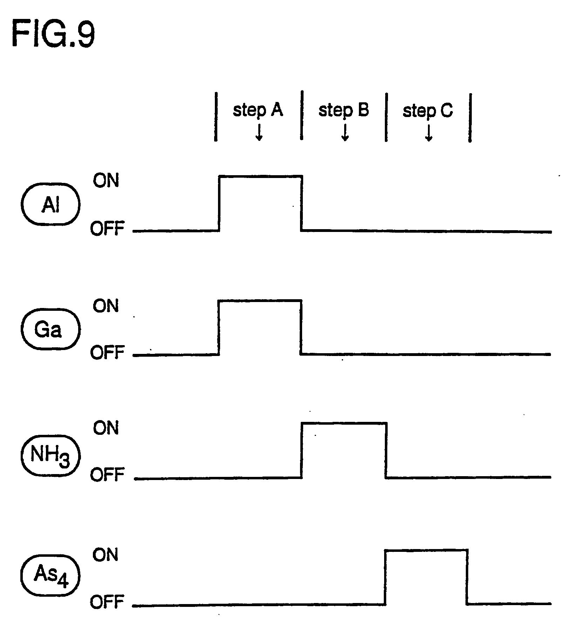

In example 1, all the source materials are supplied at the same time during the formation of an AlGaAsN layer. However, in this example, source materials are alternately supplied according to a sequence shown in Figure **9**. That is, during step A, only Al and Ga are supplied, and As₄ and NH₃ are not supplied. In this step, the beam pressures for Al and Ga are set to 1.6×10⁻⁸ torr and 2.8×10⁻⁷ torr, respectively, and the duration of supply is set to 2.0 seconds, whereby one atomic layer including Al and Ga (1:9) can be adsorbed on a surface of the substrate.

Next, at step B, only NH₃ is supplied, and Al, Ga, and As₄ are not supplied. The feed rate of NH₃ is set to 5.0 cc/min and the duration of supply is set to 10 seconds. Next, at step C, only As₄ is supplied, and Al, Ga, and NH₃ are not supplied. The beam pressure of As₄ is set to 5.0 ×10⁻⁶ torr and the duration of supply is set to 3 seconds. An Al_{0.1}Ga_{0.9}AsN layer having a thickness of 0.1 µm was formed by repeating steps A-C a plurality of times. In the thus-formed AlGaAsN layer, the nitrogen composition was 5.1%.

### (Examples 14 and 15)

Al_{0.1}Ga_{0.9}AsN layers each having a thickness of 0.1 µm were formed in the same manner as in example 13 except that the duration of NH₃ supply is set to 5 seconds (example 14) or 15 seconds (example 15). In the thus-formed AlGaAsN layer, the nitrogen composition was 2.6% in example 14 and 7.4% in example 15.

### (Comparative Example 9)

A GaAsN layer having a thickness of 0.1 µm was formed in the same manner as in example 13 except that only Ga is used as a III group element in step A. In step A, the beam pressure for Ga is set to 3.3×10⁻⁷ torr, and the duration of supply is set to 2.0 seconds, whereby one atomic layer of Ga was adsorbed on a surface of the substrate. In the thus-formed GaAsN layer, it was found as a result of the measurement by a SIMS method that the concentration of nitrogen was 5×10¹⁸ cm⁻³ (composition: 0.0022%).

Hereinafter, functions and effects of the present invention are described with reference to examples 13-15 and comparative example 9.

As a result of the research of the present inventors, it was found that, between a case where a NH₃ beam is applied to GaAs heated to about 450-640°C in an ultra-high vacuum and a case where a NH₃ beam is applied to AlGaAs, the interaction between the NH₃ beam and the surface of the substrate is considerably different. More specifically, the NH₃ beam (about 3.9 × 10⁻⁶ torr) was continuously applied for a long time, such as about 60 minutes, onto the surface of the GaAs substrate at the substrate temperature of 600°C while observing the substrate surface by electron diffraction. It was found that the substrate surface was maintained to be GaAs, and nitrogen was not adsorbed thereon at all. On the other hand, it was found from a result of observation of an electron diffraction image that, when nitrogen was supplied to AlₓGa₁₋ₓAs (x=0.05-1.0), AlₓGa₁₋ₓAs was quickly nitrided in about several minutes to several tens of minutes, and the surface thereof was transformed into AlGaN. Furthermore, it was also found that the nitriding rate is proportional to the Al composition in the mixed crystal on the surface. Thus, when Al exists on the substrate surface which is irradiated with the NH₃ beam, the decomposition of NH₃ and adsorption on the surface are significantly accelerated.

In examples 13-15, the formation of a AlGaAsN crystal having a higher nitrogen composition was attempted by utilizing the above-described effect of accelerating the decomposition of NH₃ and adsorption on the surface containing Al. First, at step A, the NH₃ beam was supplied while Al atoms and Ga atoms adsorbed on the substrate surface were exposed. NH₃ was decomposed on the exposed III group surface containing Al, and adsorption of nitrogen atoms occurs. When the application time of the NH₃ beam was set to a long time, such as one minute or more, it was observed by the surface observation with RHEED that an AlGaN crystal was generated on the surface. However, when the duration of supply is set to a short time as described in examples 13 and 14, a nitride was not deposited, and a certain amount of nitrogen atoms were adsorbed.

On the other hand, in the case where Al was not supplied in step A as in comparative example 9, even when a NH₃ beam was applied, adsorption of nitrogen atoms was not caused. Even when an application time of the NH₃ beam was set to one hour or more, the surface where only Ga atoms were exposed was not nitrided. When the NH₃ beam was used, based on presence/absence of Al atoms on the surface, whether or not nitrogen was adsorbed was determined. At subsequent step C, only As₄ was supplied, and a portion of a III group surface on which nitrogen was not adsorbed was covered with arsenic. The arsenic was adsorbed on a portion where III group atoms were exposed, and even when an excessive amount of arsenic is supplied, the supplied arsenic was evaporated without being adsorbed on the surface. In this way, through steps A-C, a single molecular layer of AlGaAsN was formed, and a crystal structure having a certain thickness was obtained by repeating this cycle a plurality of times.

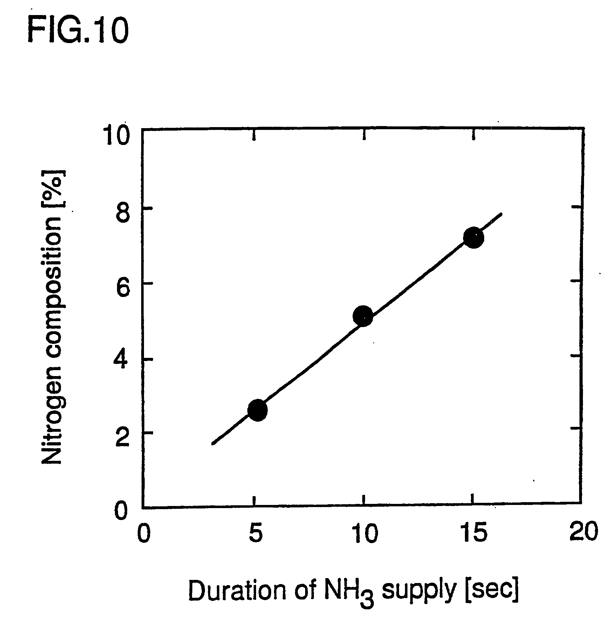

Figure 10 shows a correlation between the nitrogen composition in a sample formed in examples 13-15 of the present invention and the duration of NH₃ supply at step B. The amount of introduced nitrogen was controlled by the application time of NH₃ at step B. As compared with examples 1-4 where all the source materials were supplied at the same time, the amount of introduced nitrogen was remarkably increased even with the same feed rate of source materials and at the same substrate temperature. On the other hand, the etch pit density was not increased along with the increase in the amount of introduced nitrogen. As a result, a good crystal where phase separation did not occur was grown.

In examples 13-15, a crystal growth of a single molecular layer was performed during one cycle including: supply of III group materials including Al (step A); supply of NH₃ (step B): and supply of As₄ (step C). However, a crystal formed during one cycle is not required to be a single molecular layer, but the formation of crystal can be performed as long as an obtained crystal is a single molecular layer or smaller. However, when the obtained crystal was larger than a single molecular layer, droplets of excessive III group materials were generated at step A, and accordingly, a crystal having a coarse surface was produced.
It is needless to say that, in order to adjust the feed rate of the III group materials at step A such that crystal growth stops just at a time when a single molecular layer is completed, organometallic compounds can be used as a source material for the III group materials, and a self-limiting effect can be utilized.

Furthermore, the growth steps in the above one cycle in examples 13-15 can be variously changed as shown below.

### (Example 16)

Example 16 is a variation of example 13. A similar crystal with high quality was obtained by a method where after the supply of NH₃ at step B, at step B', a III group element (which may or may not include Al) was supplied to an amount of one atomic layer or less, and at subsequent step C, As₄ was supplied.

### (Example 17)

Example 17 is a variation of example 13. At step B, As₄ was supplied at the same time along with NH₃. A crystal with high quality similar to example 13 was obtained. Supplying NH₃ and As₄ at the same time at step B was effective in suppressing evaporation of As from a already-grown crystal, but the amount of nitrogen introduced into a growing layer was reduced. When NH₃ and As₄ were supplied at the same time at step B, the growth of III group atoms including Al exposed on the surface ceased with As on the top surface because the adsorption probability of As₄ is higher than that of NH₃. Thus, the NH₃ decomposition/adsorption accelerating effect of Al was hindered, and accordingly, introduction of nitrogen was decreased.

### (Example 18)

Example 18 is a variation of example 13. After the supply of NH₃ at step B, a suspension time of 5 seconds is provided before step C. In this case, influence of residual NH₃ in an atmosphere was reduced, and accordingly, the amount of adsorbed nitrogen was accurately controlled.

### (Example 19)

Example 19 is a variation of example 13. After the supply of As₄ at step C, a suspension time of 10 seconds was provided before performing step A. In this case, influence of residual As in an atmosphere was reduced, and accordingly, the III group elements supplied at step A were uniformly adsorbed on the substrate surface. Thus, a layer was formed so as to have a superior surface state.

The features of the variations shown in examples 16-19 can be suitably combined.

### (Example 20)

In example 20, the method of example 13 was employed except that three types of III group elements, Al, Ga, and In, were supplied at step A to an amount such that one atomic layer where Al:Ga:In is 5 : 65 : 30 was formed. Regarding NH₃ supplied at step B, the intensity and duration of the NH₃ supply beam were adjusted such that only 1.5% of nitrogen atoms were adsorbed on the surface. Step C is the same as in example 12. In this way, a Al_{0.05}Ga_{0.65}In_{0.3}N_{0.015}As_{0.985} layer having a thickness of 6 nm was formed, and this layer is sandwiched by GaAs on the upper and lower faces thereof, whereby a high-quality single quantum well which emits light at a wavelength of 1.3 µm was formed.

### (Example 21)

In example 21, the method of example 13 was employed except that the substrate was GaAs, and the substrate temperature was 550°C. Furthermore, III group elements supplied at step A were Al, Ga, and In, and a V group element supplied at step C was P. As a result, an Al_{0.05}Ga_{0.43}In_{0.52}P_{0.97}N_{0.03} layer which lattice-matched with the GaAs substrate was formed with high quality.

### (Example 22)

In example 22, the method of example 13 was employed except that the substrate was InP, and the substrate temperature was 550°C. Furthermore, III group elements supplied at step A were Al and In, and V group elements supplied at step C were As and P. As a result, a Al_{0.05}In_{0.95}As_{0.014}P_{0.96}N_{0.025} layer which lattice-matched with InP substrate was formed with high quality.

### (Example 23)

In example 23, the method of example 13 was employed except that the substrate was Si, and the substrate temperature was 600°C. Furthermore, a V group element supplied at step C was P. As a result, a Al_{0.15}Ga_{0.85}P_{0.978}N_{0.022} layer which lattice-matched with Si substrate was formed with high quality.

### (Example 24)

In example 24, the method of example 13 was employed except that the substrate temperature was 550°C. Furthermore, V group elements supplied at step C were As and Sb. As a result, a Al_{0.3}Ga_{0.7}As_{0.803}Sb_{0.142}N_{0.055} layer which lattice-matched with GaAs substrate was formed with high quality.

The crystals formed in examples 13 and 14 each had a considerably low concentration of residual carbon impurity as compared with a crystal formed by a conventional method. Furthermore, each crystal was a high-quality crystal where the etch pit density is low.

Above examples 13-24 show a sequence of a crystal growth method which utilizes a fact that when a III group end face including Al is formed in an outermost surface, and NH₃ is applied thereon, nitrogen atoms can be efficiently adsorbed on the surface. On the other hand, examples 25-28 below show a sequence of a crystal growth method which utilizes a fact that when NH₃ is applied to an end face of V group element (V group elements other than nitrogen, such as arsenic, phosphorus, antimony, etc.) of a crystal containing Al, some of the V group elements (elements other than nitrogen, such as arsenic, phosphorus, antimony, etc.) can be substituted with nitrogen.

### (Example 25)

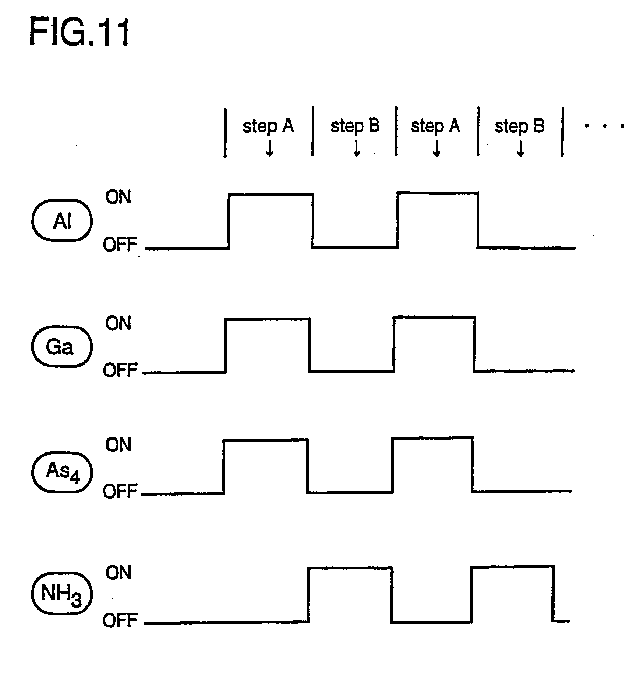

In example 25, a crystal growth method used is a MBE method which is the same as that of example 1. Source materials for respective elements, the substrate temperature during the crystal growth, the type of a substrate used are also the same as those of example 1. The source materials are supplied according to a sequence shown in Figure 11. That is, at step A, Al, Ga, and As₄ are supplied to form a thin film of AlGaAs. In this step, the beam pressures for Al, Ga, and As₄ are set to 1.6 × 10⁻⁸ torr, 2.8 × 10⁻⁷ torr, and 1.0 × 10⁻⁵ torr, respectively, and the duration of supply is set to 2.0 seconds, whereby one atomic layer can be formed on a surface of the substrate. Since the As pressure is sufficiently high so that a surface superstructure of (4 ×2) is formed, an outermost surface results in as As stable surface which ends with As atoms. Next, at step B, only NH₃ is supplied on the resultant As surface, and Al, Ga, and As₄ are not supplied. The feed rate of NH₃ is set to 5.0 cc/min, and the duration of supply is set to 10 seconds. In this step, some As in the outermost surface is substituted with nitrogen atoms. By repeating the above steps A and B a plurality of times, a Al_{0.1}Ga_{0.9}AsN layer was formed so as to have a thickness of 0.1 µm. In the thus-formed AlGaAsN layer, the nitrogen composition was 3.0%.

### (Comparative Example 10)

A GaAsN layer having a thickness of 0.1 µm was formed in the same manner as example 13 except that a GaAs thin layer was formed by supplying only Ga and As₄ as the source materials supplied at step A (Figure **11**) in example 25. The beam pressure for Ga at step A was set to 3.3×10⁻⁷ torr, and the duration of supply is set to 2.0 seconds, whereby one atomic layer of GaAs was formed on a surface of the substrate. The nitride concentration in the thus-formed GaAsN layer measured by a SIMS method was 2.3×10¹⁸ cm⁻³ (0.001% in composition).

Hereinafter, a function and an effect of the present invention are described with reference to example 25 and comparative example 10.

As a result of the research of the present inventors, it was found that, between a case where a NH₃ beam is applied to GaAs heated to about 450-640°C in an ultra-high vacuum and a case where a NH₃ beam is applied to AlGaAs, the interaction between the NH₃ beam and the surface of the substrate is considerably different. More specifically, the NH₃ beam (about 3.9×10⁻⁶ torr) was continuously applied for a long time, such as about 60 minutes, onto the surface of the GaAs substrate at the substrate temperature of 600°C while observing the substrate surface by electron diffraction. It was found that the substrate surface maintained to be GaAs, and an interaction with NH₃ did not occur. On the other hand, it was found from a result of observation of a photoluminescence measurement that, when nitrogen was applied to AlₓGa₁₋ₓAs (x=0.05-1.0) for about several seconds to several tens of seconds, arsenic atoms were substituted with nitrogen atoms, whereby a AlₓGa₁₋ₓAsN mixed crystal layer was formed. When a crystal containing Al is irradiated with the NH₃ beam, the decomposition of NH₃ and adsorption on the surface are significantly accelerated.

In example 25, the formation of an AlGaAsN crystal was attempted by utilizing the above-described effect of accelerating the decomposition of NH₃ and adsorption on the surface containing Al. First, at step A, an AlGaAs thin layer was formed, and at step B, the NH₃ beam was supplied to the formed layer. NH₃ was decomposed on the surface of a crystal containing Al, and arsenic atoms were substituted with nitrogen atoms. When the application time of the NH₃ beam was set to a long time, such as one minute or more, it was observed by the surface observation with RHEED that a AlGaN crystal was generated on the surface. However, when the duration of supply is set to a short time as described in example 25, a nitride was not deposited, and a certain amount of arsenic atoms were substituted with nitrogen atoms.

On the other hand, in the case where a crystal layer not containing Al was formed at step A as in comparative example 10, even when a NH₃ beam was applied, substitution with nitrogen atoms were not caused. Even when an application time of the NH₃ beam was set to one hour or more, no change occurred in a (2×4) GaAs surface which ends with As. When the NH₃ beam was used, based on presence/absence of Al atoms on a crystal, whether or not substitution with nitrogen occurred was determined. In this way, through steps A and B, a single molecular layer of AlGaAsN was formed, and a crystal having a certain thickness was obtained by repeating this cycle a plurality of times.

### (Example 26)

This example is a variation of example 25, and is different from example 25 only in that an AlGaAs layer grown at step A includes two molecular layers. That is, the growth time at step A was set to be two times longer than that in example 25 so as to form two molecular layers, and subsequently, step B was performed, whereby arsenic atoms in AlGaAs were substituted with nitrogen atoms so as to form two molecular layers of AlGaAsN. By repeating this cycle a plurality of times, a crystal having a predetermined thickness was obtained. This was achieved by utilizing a fact that, when a AlGaAs layer is irradiated with a NH₃ beam for a short time, the substituted arsenic atoms are not limited only to arsenic atoms in the outermost surface, and nitrogen is introduced to a depth of several tens of nanometers. As a result, in the AlGaAs layer formed at step A which includes two molecular layers, in both of these two layers, arsenic atoms were substituted with nitrogen atoms, whereby a AlGaAsN crystal was obtained. This method is advantageous when forming a crystal so as to have a predetermined thickness in that the number of times the source materials are changed is reduced as compared with the method of example 25.

In this example, the AlGaAs layer formed at step A includes two molecular layers. However, it is needless to say that the AlGaAs layer may include any number of layers, such as three molecular layers, five molecular layers, etc., so long as substitution with nitrogen is possible. Furthermore, an AlGaAs layer including 2.5 molecular layers is possible. That is, the number of molecular layers is not necessarily limited to a natural number.

### (Example 27)

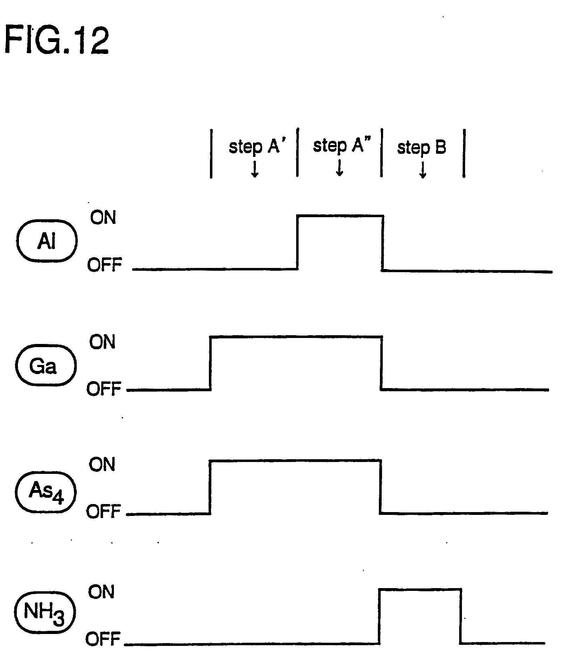

This example is a variation of example 26, and is different from example 26 in that step A in example 26 is divided into two steps A' and A" as shown in Figure **12.** First, at step A', a GaAs layer of one molecular layer is grown. Subsequently, at step A", an AlGaAs layer of one molecular layer is grown. Then, step B is performed so that arsenic atoms in the GaAs layer formed at step A' and the AlGaAs layer formed at step A" are substituted with nitrogen atoms. Repeating this cycle, a crystal having a predetermined thickness can be obtained. This was achieved by utilizing a fact that, when a layer including Al (AlGaAs formed at step A") exists in the outermost surface, decomposition of NH₃ and the adsorption of nitrogen on the surface are accelerated by Al, and accordingly, arsenic atoms included in an underlying layer not including Al (GaAs formed at step A') are also substituted with nitrogen atoms. This method is advantageous when forming a crystal having a predetermined nitrogen composition in that the amount of Al added in the crystal can be reduced, and the variation of the energy bandgap which may be caused by Al can be reduced.

In this example, the layers formed at step A' and step A" each include one molecular layer. However, it is needless to say that each of the layers formed at step A' and step A" may include any number of layers, such as two molecular layers, three molecular layers, etc., so long as substitution with nitrogen is possible. Furthermore, a layer including 2.5 molecular layers is possible. That is, the number of molecular layers is not necessarily limited to a natural number.

### (Example 28)

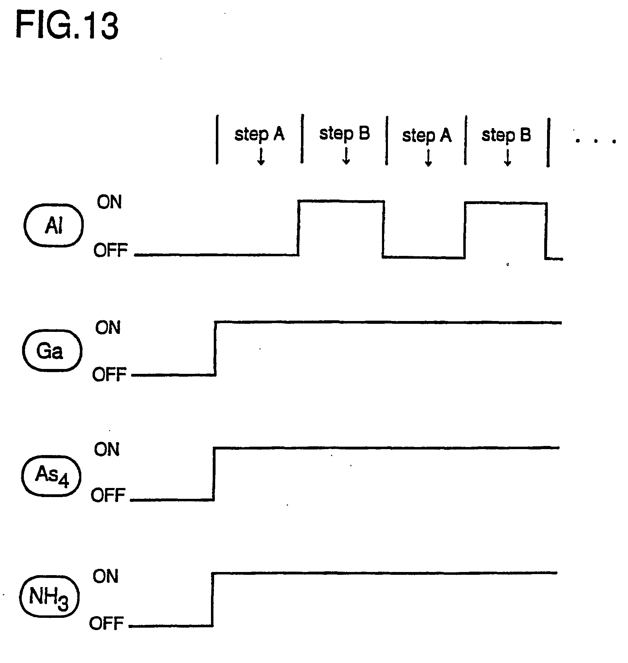

This example is a variation of example 27, and is characterized in that only an Al source material is intermittently supplied. A supply sequence of respective source materials according to this example is shown in Figure **13.** First, at step A, a Ga molecular beam, an As₄ molecular beam, and a NH₃ molecular beam, which are source materials of Ga, As, and N, respectively, are supplied to grow a GaAs layer of one molecular layer. At this step, substantially no nitrogen is introduced into a crystal. Subsequently, at step B, a Al molecular beam, a Ga molecular beam, a As₄ molecular beam, and a NH₃ molecular beam, which are source materials of Al, Ga, As, and N, respectively, are supplied to grow a AlGaAsN layer of one molecular layer. At this step, decomposition of NH₃ and the adsorption of nitrogen are accelerated by Al. Nitrogen is introduced in a crystal, and some of arsenic atoms in the underlying GaAs layer formed at step A are substituted with nitrogen atoms. By repeating this cycle a plurality of times, a crystal having a predetermined thickness was obtained. This method is advantageous when forming a crystal having a predetermined nitrogen composition in that the amount of Al added in the crystal can be reduced, and the variation of the energy bandgap which may be caused by Al can be reduced.

In this example, the layers formed at step A and step B each include one molecular layer. However, it is needless to say that each of the layers formed at step A and step B may include other number of layers, such as two molecular layers, three molecular layers, etc. The layer formed at step A may include any number of layers so long as substitution with nitrogen is possible. Furthermore, a layer including 2.5 molecular layers is possible. That is, the number of molecular layers is not necessarily limited to a natural number.

The crystals formed in examples 25-28 each had a considerably low concentration of residual carbon impurity as compared with a crystal formed by a conventional method. Furthermore, each crystal formed was a high-quality crystal where the etch pit density is low.

In examples 25-28, a "suspension" time when no source material is supplied may be provided between respective steps in order to remove a residual source material. Further, at step B, only NH₃ gas is supplied. However, the NH₃ gas may be supplied together with other V group source material such as an arsenic source material. In such a case, excessive evaporation of arsenic atoms from a crystal surface can be suppressed. Furthermore, in each example, only the formation of a AlGaAsN crystal has been described. However, by the same method, a crystal which includes, as V group components in its composition, nitrogen and a V group element other than nitrogen, such as a AlGaInPN crystal, a AlInAsPN crystal, a AlGaPN crystal, a AlGaAsSbN crystal, etc., can be formed. In this case, at steps A, A', and A", thin layers such as a (Al)GaInP layer, a (Al)InAsP layer, a (Al)GaP layer, a (Al)GaAsSb layer, etc., may be suitably formed, and at step B, a portion of a V group element may be substituted with nitrogen by application of NH₃. If a layer including Al as a component of its composition has been formed immediately before step B, at step B, substitution of a V group element with nitrogen from NH₃ is accelerated.

In examples 29 and 30, an application example of the present invention to the formation of wire-shaped semiconductor microstructure is specifically described.

### (Example 29)

In this example, the above-described fact that when NH₃ is applied to a semiconductor layer, substitution with nitrogen can be selectively achieved only in a layer including Al, is applied to the production of a gain-coupled distributed feedback semiconductor laser having an absorptive diffraction grating.

In this example, crystal growth was performed by a crystal growth apparatus which is the same as that used in example 1. As an In source material, In metal was added. The substrate temperature during the crystal growth was 550°C.

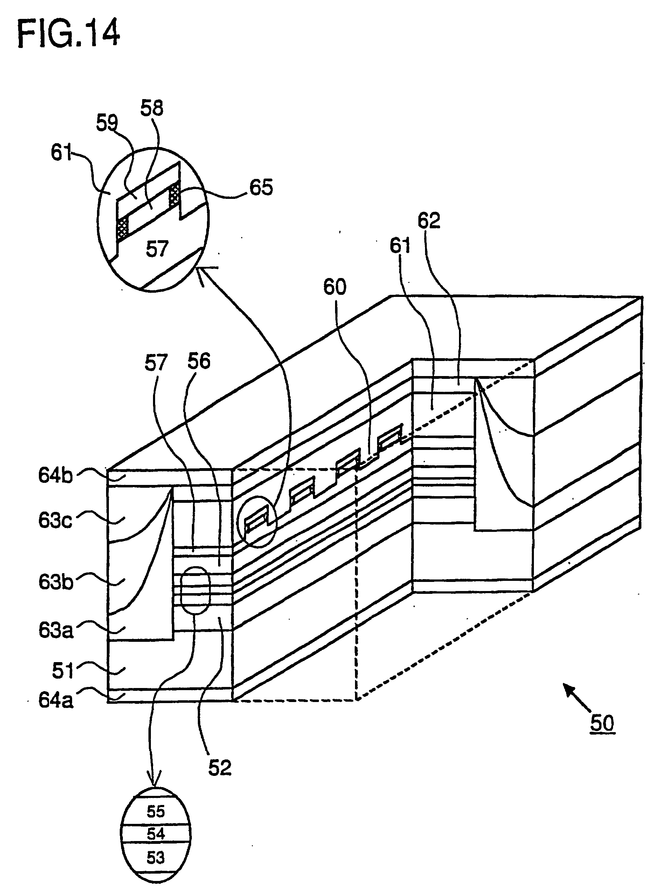

Hereinafter, a gain-coupled distributed feedback semiconductor laser **50** shown in Figure **14** and a device structure thereof are described in detail while following the production procedure.

First, a low-resistive n-type GaAs (100) substrate **51** was introduced in a MBE apparatus, and the following layers were formed by a first crystal growth operation:
a lower cladding layer **52:** n-type Al_{0.3}Ga_{0.7}As, thickness of 1.0 µm;
a lower guiding layer **53:** undoped GaAs, thickness of 0.1 µm ;
a well layer **54:** undoped Al_{0.1}Ga_{0.58}In_{0.32}N_{0.019}As_{0.981}, thickness of 6 nm;
an upper guiding layer **55**: undoped GaAs, thickness of 0.1 µm;
a carrier block layer **56:** p-type Al_{0.3}Ga_{0.7}As, thickness of 0.1 µm;
a lower waveguide layer **57**: p-type GaAs, thickness of 0.1 µm ;
a buried layer **58:** p-type Al_{0.05}In_{0.2}Ga_{0.75}As, thickness of 0.03 µm;
an upper waveguide layer **59:** p-type GaAs, thickness of 0.02 µm.

Herein, the material and thickness of the well layer **54** are selected such that an active layer has a gain at a wavelength of 1.3 µm.

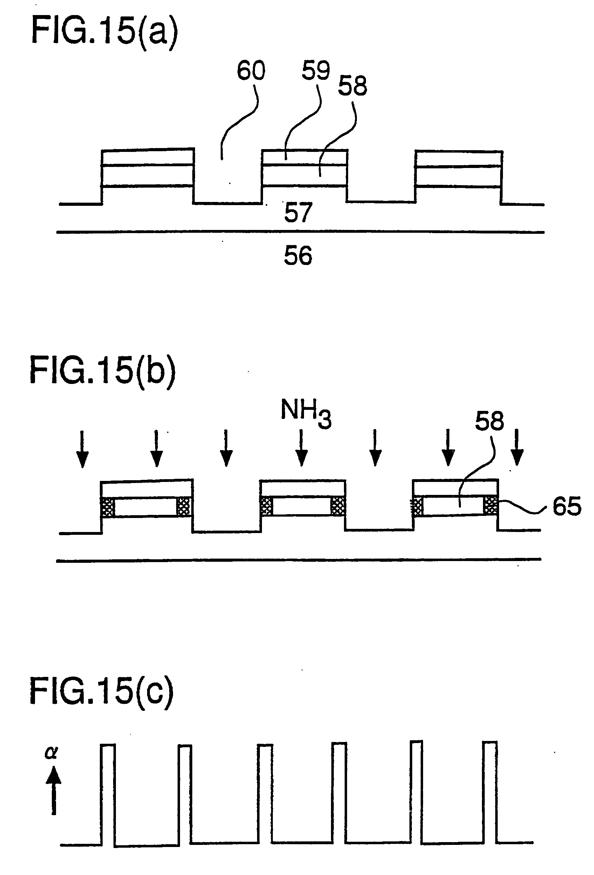

This layered structure was taken out from the MBE apparatus, and a rectangular diffraction grating **60** having a pitch of 0.195 µm and a depth of 0.1 µm was engraved on a surface of the layered structure by two-beam interference exposure and dry etching. The pitch of the diffraction grating **60** was selected such that the Bragg wavelength accords with a peak wavelength of the gain of the active layer at room temperature. Figure **15(a)** shows a cross-section of the engraved diffraction grating **60**. A flat portion of a convex of the diffraction grating **60** is an exposed upper waveguide layer **59**; and a flat portion of a concave of the diffraction grating **60** is an exposed lower waveguide layer **57**. On vertically-etched side faces, side faces of the disconnected buried layer **58** of AlInGaAs are exposed.

Next, the layered structure with the diffraction grating engraved on its surface was again introduced into the MBE apparatus and heated to a substrate temperature of 550°C in an ultra-high vacuum. To the layered structure, a NH₃ gas molecular beam was applied for 10 seconds at a feed rate of 5 cc/min. At this time, over the surface of the diffraction grating, only the buried layer **58** including Al which gives a cracking-catalytic effect to NH₃ interacts with NH₃. 3% of V group atoms in a portion exposed over the surface are substituted with nitrogen atoms, and the exposed portion is transformed into AlGaInAsN having an energy bandgap of 0.82 eV to form an absorber layer **65** (Figure **15(b)**). If NH₃ is applied for a long time, a portion of the buried layer **58** exposed over the surface is transformed into a nitride, i.e., AlGaInN. However, when NH₃ is applied for a short time as in this example, only some of V group atoms are substituted with nitrogen. The lower waveguide layer **57** and the upper waveguide layer **59** not containing Al do not react with NH₃ even when NH₃ is applied. As seen from Figure **15(c)** showing the distribution of absorption coefficient α in the absorber layer **65,** the absorber layer **65** absorbs induced emission light at a wavelength of 1.3 µm.

Subsequently, in the MBE apparatus, a second crystal growth operation was performed to form the following layers over the diffraction grating:
an upper cladding layer **61:** p-type Al_{0.3}Ga_{0.7}As, thickness of 0.5 µm;
a contact layer **62:** p⁺-type GaAs, thickness of 0.5 µm.

This resultant layered structure was taken out from the MBE apparatus, and mesa stripes each having a width of 2 µm were formed by common photolithography and wet etching along a direction perpendicular to the diffraction grating. Thereafter, the outside of the mesa stripes was buried with three current confinement layers **63a, 63b,** and **63c** respectively made of p-type Al_{0.4}Ga_{0.6}As, n-type Al_{0.4}Ga_{0.6}As, and p-type Al_{0.4}Ga_{0.6}As, and electrodes **64a** and **64b** were formed by vacuum deposition on the upper and lower faces of the resultant structure. The resultant structure was cleaved so as to have a cavity length of 300 µm, thereby completing a gain-coupled distributed feedback semiconductor laser device as shown in Figure **14.**

When a current was applied to the produced semiconductor laser device through the upper and lower electrodes **64a** and **64b**, the laser oscillation was performed at a threshold current of 3 mA and at a wavelength of 1.3 µm. The laser light exhibited a stable oscillation at a single wavelength.

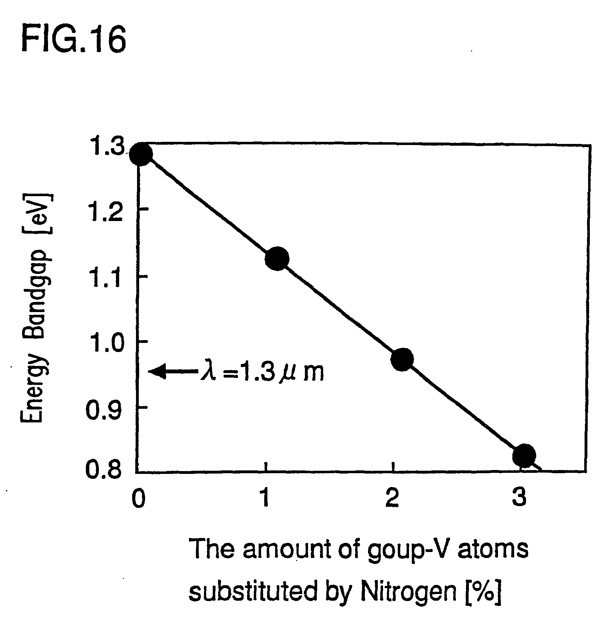

Figure **16** shows the variation of the energy bandgap in AlGaInAs, which is the material of the buried layer, when some arsenic atoms are substituted with nitrogen atoms. When some of V group atoms in AlGaInAs is substituted with nitrogen, the energy bandgap is monotonously narrowed. When 2.1% or more of arsenic atoms are substituted with nitrogen, AlGaInAs absorbs induced emission light having a wavelength of 1.3 µm (=0.954 eV). On the other hand, in GaAs of the guidewave layers which are provided over and below AlGaInAs, arsenic atoms are not substituted with nitrogen atoms, and therefore, GaAs is transparent to the induced emission light having a wavelength of 1.3 µm. In the process described with reference to Figure 15, the process conditions are selected such that 3% of arsenic atoms are substituted with nitrogen atoms so as to form an absorptive diffraction grating alternately including wires which deeply absorbs induced emission light having a wavelength of 1.3 µm and transparent regions as shown in the distribution chart of absorption coefficient α of Figure **15(c)**.

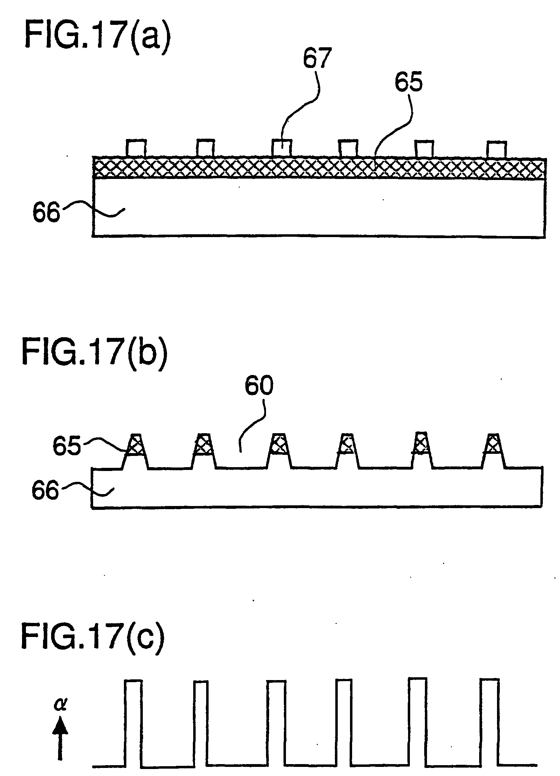

When such wire-shaped periodical absorptive regions are provided in an optical cavity of a semiconductor laser, only a stationary wave whose absorption loss from the wire-shaped absorptive regions is minimum, i.e., only a stationary wave whose nodes are within the wire-shaped absorptive regions, selectively satisfies the oscillation condition, and as a result, a stable oscillation at a single wavelength can be achieved. Herein, it is desirable that the width of the wire-shaped absorptive regions is as narrow as possible. When the wire-shaped absorptive regions have a large width, the absorption loss in the selected stationary wave is increased, and the oscillation efficiency is largely decreased. Conventionally, in such an absorptive diffraction grating alternately including absorptive regions and transparent regions, as shown in Figure **17**, a transparent layer **66** and an absorber layer 65 are formed in the vicinity or active layer of a semiconductor laser; a periodical resist mask **67** is formed by two-beam interference exposure (Figure **17(a)**); the absorber layer **65** is periodically etched by wet etching so as to thin the absorber layer **65** (Figure **17(b)**), whereby periodical absorption distribution of a narrow width is obtained (Figure **17(c)**). In general, the pitch of the diffraction grating is about 0.2 µm (first diffraction grating in a DFB-LD of 1.3-1.55 µm band). For example, when forming an absorptive diffraction grating having a duty ratio of 0.1 or less, it is necessary to control the width of the absorber layer **65** to be 20nm or less. In a conventional method, the width of an absorptive diffraction grating changes according to the width of the resist mask **67** formed by a two-beam interference exposure and the extent of subsequent etching. That is, it is difficult to control and uniformly form the narrow wires having a width of tens of nanometers by the process using a common resist with high reproducibility.

On the other hand, in an absorptive diffraction grating produced in this example, the pitch of a periodical absorber layer obtained is a half of the pitch of the diffraction grating formed in the first step by etching and two-beam interference exposure. Thus, the diffraction grating formed in the first step by etching and two-beam interference exposure may have a pitch two times larger as compared with the conventional method, and accordingly, the production is easier. Furthermore, the duty ratio of the diffraction grating formed in this case is about 0.5, at which the diffraction grating is most readily formed by two-beam interference exposure, and a superior controllability can be obtained as compared with the conventional method. The width of the wire-shaped absorber layer (duty ratio of the absorptive diffraction grating) is determined by the extent of a region where a portion of the composition of a buried layer is substituted with nitrogen (i.e., depth from a surface) so that superior reproducibility and in-plane distribution can be obtained as compared with the conventional method. Furthermore, since the depth from the surface of the region where arsenic is substituted with nitrogen is 10 nm or less, an absorptive diffraction grating having a considerably small width can be obtained.

Furthermore, in this example, a rectangular diffraction grating having a vertical side faces is formed by using dry etching, whereby an absorber layer having a small width is formed. However, the diffraction grating may be formed by wet etching so as to have a trapezoidal shape, a triangular shape, a sine wave shape, or the like. Specifically, by engraving a diffraction grating along a crystal direction such that a cross-section of the diffraction grating has an inverted mesa shape, a rectangular diffraction grating having a vertical cross-section can be produced even by wet etching.

The thus-formed absorptive diffraction grating can form a periodical light absorbing layer having a small wire width, and an excessive absorption loss in induced emission light from the absorptive diffraction grating can be sufficiently reduced. On the other hand, in an absorber layer which is formed by substituting arsenic atoms in a buried layer containing Al in its composition with nitrogen atoms, the energy bandgap is abruptly narrowed by the small substitution with nitrogen, and a locally deep absorption is caused in an absorptive portion having a small wire width. Thus, such an absorber layer is necessary and sufficient for stabilizing the position of a stationary wave in an optical cavity. As a result, a gain-coupled distributed feedback semiconductor laser which oscillates at a low threshold value and which has an excellent single longitudinal mode characteristic is obtained.

In this example, an example where AlGaInAs is used as a material for the buried layer has been specifically described. However, as described in each of the above examples, the same effects can also be obtained even with another material so long as the material includes Al in its composition. However, in such a case, the material needs to have a capacity for absorbing induced emission light from an active layer when several percentages or less of V group element is substituted with nitrogen. For example, AlGaAs, AlGaInP, AlGaInAsP, AlGaSbAs, or the like, can be employed.

Furthermore, in this example, as a structure of a distributed feedback semiconductor laser, a structure where a diffraction grating is provided in an upper portion of the active layer has been described. However, the diffraction grating may be provided in a lower portion of the active layer. Further still, the diffraction grating may be provided only in a portion of the optical cavity. An absorptive diffraction grating having the same structure may be used in a DBR section of a distributed Bragg reflector semiconductor laser, and can be a wavelength-tunable laser, a wavelength filter, an optical amplifier, etc.

### (Example 30)

In this example, the above-described fact that when NH₃ is applied to a semiconductor layer, substitution with nitrogen can be selectively achieved only in a layer including Al, is applied to the production of a semiconductor laser having quantum wires in an active layer.

In this example, crystal growth was performed by a crystal growth apparatus which is the same as that used in example 1. As an In source material, In metal was added. The substrate temperature during the crystal growth was 550°C.

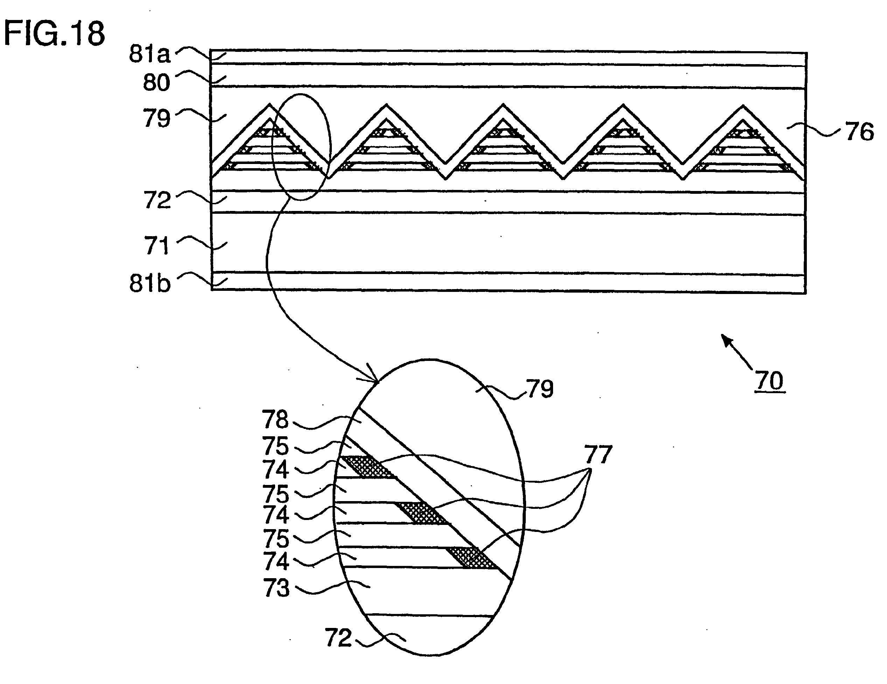

Hereinafter, a semiconductor laser **70** shown in Figure **18** and a device structure thereof are described in detail while following the production procedure.

First, a low-resistive n-type GaAs (100) substrate **71** was introduced in a MBE apparatus, and the following layers were formed by a first crystal growth operation:
a lower cladding layer **72:** n-type Al_{0.3}Ga_{0.7}As, thickness of 1.0 µm;
a lower guiding layer **73:** undoped GaAs, thickness of 0.1 µm;
a buried layer **74:** undoped Al_{0.1}Ga_{0.7}In_{0.2}As, thickness of 8 nm;
a barrier layer **75:** undoped GaAs, thickness of 30 nm;
a buried layer **74:** undoped Al_{0.1}Ga_{0.7}In_{0.2}As, thickness of 8 nm;
a barrier layer **75:** undoped GaAs, thickness of 30 nm;
a buried layer **74:** undoped Al_{0.1}Ga_{0.7}In_{0.2}As, thickness of 8 nm;
a barrier layer **75:** undoped GaAs, thickness of 30 nm.

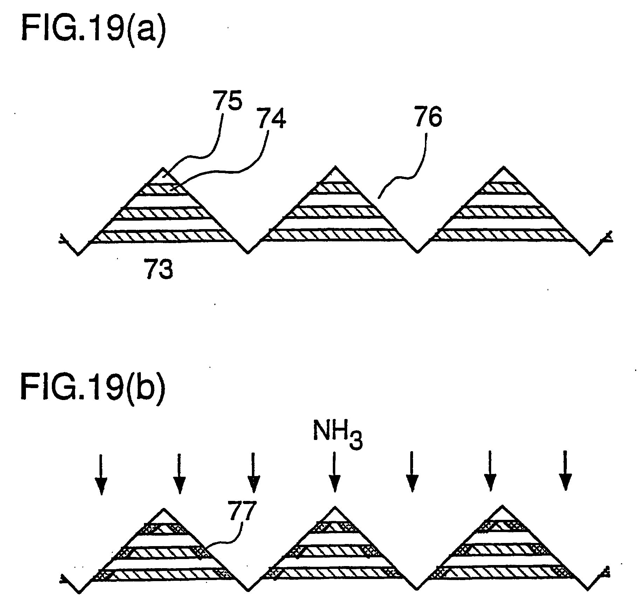

This layered structure was taken out from the MBE apparatus, and a triangular diffraction grating **76** having a pitch of 0.2 µm and a depth of 0.15 µm was engraved on a surface of the layered structure by electron beam exposure and wet etching. Figure **19(a)** shows a cross-section of the engraved diffraction grating **76**. The diffraction grating was formed so as to disconnect the three buried layers **74**. The disconnected buried layers **74** of AlInGaAs are exposed on the etched slant surface.

Next, the layered structure with the diffraction grating engraved on its surface was again introduced into the MBE apparatus and heated to a substrate temperature of 550°C in an ultra-high vacuum. To this layered structure, a NH₃ gas molecular beam was applied for 7 seconds at a feed rate of 5 cc/min. At this time, over the surface of the diffraction grating, only the buried layers **74** including Al, which gives a cracking-catalytic effect to NH₃, interact with NH₃. 2% of V group atoms in a portion exposed over the surface are substituted with nitrogen atoms, and the exposed portion is transformed into AlGaInAsN having an energy bandgap of 1.05 eV to form quantum wires **77** (Figure **19(b)**).

If NH₃ is applied for a long time, a portion of the buried layers **74** exposed over the surface is transformed into a nitride, i.e., AlGaInN. However, when NH₃ is applied for a short time as in this example, only some of V group atoms are substituted with nitrogen. The lower guiding layer **73** and the barrier layer **75** not containing Al do not react with NH₃ even when NH₃ is applied. It should be noted that the engraving direction of the diffraction grating was selected such that a (111)A surface is exposed on the etched surface of the diffraction grating. According to the researches of the present inventors, it has already been known that the nitrogen substitution efficiency in a {n11}A surface (n=1, 2, 3, ...) is higher than in a {n11}B surface (n=1, 2, 3, ...). Thus, the {n11}A surface (n=1, 2, 3,...) is desirable as an etching face in which substitution with nitrogen is performed.

Subsequently, in the MBE apparatus, a second crystal growth operation was performed to form the following layers over the diffraction grating:
an upper guiding layer **78:** undoped GaAs, thickness of 50 nm;
an upper cladding layer **79:** n-type Al_{0.3}Ga_{0.7}As, thickness of 1.0 µm;
a contact layer **80**: p⁺-type GaAs, thickness of 0.5 µm.

This resultant layered structure was taken out from the MBE apparatus, and mesa stripes each having a width of 1.5 µm were formed by common photolithography and wet etching along a direction perpendicular to the diffraction grating. Thereafter, the outside of the mesa stripes was buried with three current confinement layers respectively made of p-type Al_{0.3}Ga_{0.7}As, n-type Al_{0.3}Ga_{0.7}As, and p-type Al_{0.3}Ga_{0.7}As (not shown), and electrodes **81a** and **81b** were formed by vacuum deposition on the upper and lower faces of the resultant structure. The resultant structure was cleaved so as to have a cavity length of 200 µm, thereby completing a semiconductor laser device as shown in Figure **18**.

When a current was applied to the produced semiconductor laser device through the upper and lower electrodes **81a** and **81b**, the laser oscillation was performed at a threshold current of 1 mA.

In a semiconductor laser of this example, the quantum wires **77** formed according to the process described with reference to Figure **19** function as an active layer. That is, within a portion of the exposed surface of the diffraction grating **76** which includes Al in its composition, a V group element is substituted with nitrogen, and the energy bandgap is significantly narrowed, carriers can be confined in the shape of a wire. The width of the wire-shaped active layer is determined by the extent of a region where a portion of the composition of the buried layers **74** is substituted with nitrogen (i.e., depth from a surface) so that superior reproducibility and in-plane distribution can be obtained. Furthermore, since the depth from the surface of the region where arsenic is substituted with nitrogen is 10 nm or less, quantum wires having a considerably small widths can be obtained. Furthermore, in this example, a triangular diffraction grating is formed, whereby quantum wires are formed. However, the diffraction grating may be formed so as to have a trapezoidal shape, a rectangular shape, a sine wave shape, or the like.

In this example, an example where AlGaInAs is used as a material for the buried layer has been specifically described. However, the same effects can also be obtained even with another material so long as the material includes Al in its composition. For example, AlGaAs, AlGaInP, AlGaInAsP, AlGaSbAs, or the like, can be employed.

Furthermore, the structure of a Fabry-Perot semiconductor laser has been described. However, when the pitch of the diffraction grating is selected such that the Bragg wavelength which is determined based on the pitch of the diffraction grating substantially accords with a gain wavelength of a quantum wire active layer, a gain diffraction grating-type distributed feedback semiconductor laser in which the gain of the active layer is periodically modulated can be readily obtained.

In an active layer formed by the above method, the residual carbon impurity concentration and the etch pit density are considerably low as compared with an active layer formed by a conventional method. Thus, such an active layer can produce a high optical gain, and a semiconductor laser with high performance can be constructed.

### (Example 31)

A GaAs substrate which has, on its surface, crystal faces which are slanted from a (100) surface in a [011] direction (A-direction) at angles of 0°, 2°, 5°, 10°, 15°, and 25° was used. Over the GaAs substrate, a single quantum well structure including a well layer of Al_{0.1}Ga_{0.9}As_{1-z}N_{z} having a thickness of 8 nm, and upper and lower barrier layers of Al_{0.3}Ga_{0.7}As having a thickness of 0.5 µm was produced. The Al_{0.1}Ga_{0.9}As_{1-z}N_{z} well layer was formed by the same crystal growth method and under the same crystal growth conditions as in example 2.

### (Comparative Example 11)

A GaAs substrate which has, on its surface, a crystal face which is slanted from a (100) surface in a [011] direction (A-direction) at an angle of 55° was used. Over the GaAs substrate, a single quantum well structure including a well layer of Al_{0.1}Ga_{0.9}As_{1-z}N_{z} having a thickness of 8 nm, and upper and lower barrier layers of Al_{0.3}Ga_{0.7}As having a thickness of 0.5 µm was produced. The Al_{0.1}Ga_{0.9}As_{1-z}N_{z} well layer was formed by the same crystal growth method and under the same crystal growth conditions as in example 2.

The above slanted substrates of example 31 and comparative example 11 are generally represented as a (n11)A surface (n=1, 2, 3, ···). For example, a crystal face which is slanted from a (100) surface in a [011] direction (A-direction) at an angle of 10° is a (811)A surface; a crystal face which is slanted from a (100) surface in a [011] direction (A-direction) at an angle of 25° is a (311)A surface; and a crystal face which is slanted from a (100) surface in a [011] direction (A-direction) at an angle of 55° is a (111)A surface.

### (Comparative Example 12)

A GaAs substrate which has, on its surface, crystal faces which are slanted from a (100) surface in a [0-11] direction (B-direction) at angles of 2°, 5°, 10°, 15°, 25°, and 55° was used. Over the GaAs substrate, a single quantum well structure including a well layer of Al_{0.1}Ga_{0.9}As_{1-z}N_{z} having a thickness of 8 nm, and upper and lower barrier layers of Al_{0.3}Ga_{0.7}As having a thickness of 0.5 µm were produced. The Al_{0.1}Ga_{0.9}As_{1-z}N_{z} well layer was formed by the same crystal growth method and under the same crystal growth conditions as in example 2.

The above slanted substrate is generally represented as a (n11)B surface (n=1, 2, 3,···). For example, a crystal face which is slanted from a (100) surface in a [0-11] direction (B-direction) at an angle of 10° is a (811)B surface; a crystal face which is slanted from a (100) surface in a [0-11] direction (B-direction) at an angle of 25° is a (311)B surface; and a crystal face which is slanted from a (100) surface in a [011] direction (B-direction) at an angle of 55° is a (111)B surface.

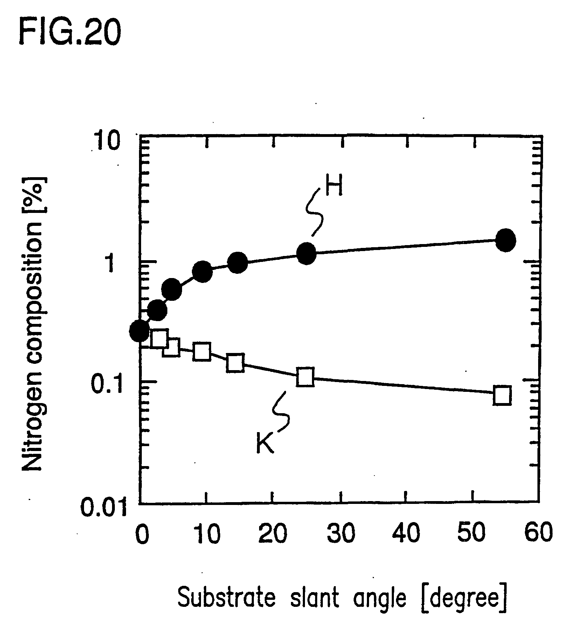

A measurement result of the nitrogen composition z in the Al_{0.1}Ga_{0.9}As_{1-z}N_{z} single quantum well layer formed in examples 2 and 31 and comparative examples 11 and 12 is shown in Figure **20**. The nitrogen composition z was measured from the light wavelength of a photoluminescence wave in the quantum well.

In the case of example 31 and comparative example 11 where a crystal is grown on a substrate slanted at an angle of 2° to 55° in [011] direction (A-direction), the nitrogen composition in the crystal increases according to the increase of the slant angle. In the case of comparative example 12 where a crystal is grown on a substrate slanted in [0-11] direction (B-direction), the nitrogen composition in the crystal decreases according to the increase of the slant angle. This is because on a surface of the substrate slanted from a (100) surface in a [011] direction (A-direction), an atomic step (A step) which ends with a III group atom (Ga or Al) is formed. That is, the probability that an undecomposed or physically-absorbed NH₃-decomposition species which has reached an end of the step encounters an active Al atom at the step end increases, and accordingly, decomposition and adsorption are accelerated, and nitrogen is readily introduced into a crystal.

On the other hand, on a surface of the substrate slanted in [0-11] direction (B-direction), an atomic step (B step) which ends with a V group atom (As or N) is formed. In this case, the probability that an undecomposed or physically-absorbed NH₃-decomposition species which has reached an end of the step encounters an active Al atom at the step end is very low, and accordingly, nitrogen atoms are not readily introduced into a crystal.

In the case of a non-slanted (100) surface, the direction of a kink site in the outermost surface of the crystal into which a N atom is introduced is not controlled, an A step may be formed, and a B step may be formed. That is, in this case, the introduction characteristic of N atoms is intermediate between the characteristic obtained when a crystal is formed on a surface slanted in [011] direction (A-direction) and the characteristic obtained when a crystal is formed on a surface slanted in [0-11] direction (B-direction).

In the case of improving the introduction efficiency of nitrogen into a crystal by using NH₃ as a nitrogen source material and adding Al, it was found that the effect of NH₃ and Al can be more positively utilized by using a substrate which is slanted from a (100) surface in a [011] direction (A-direction). This function/effect is unique to the structure of the present invention which improves the efficiency of use of a NH₃ source material by Al atoms existing on a surface of a growing crystal. It should be noted that in the case where Al was not included, even when a GaAsN layer was grown on a substrate slanted in the A-direction, introduction of sufficient amount of nitrogen did not occur.

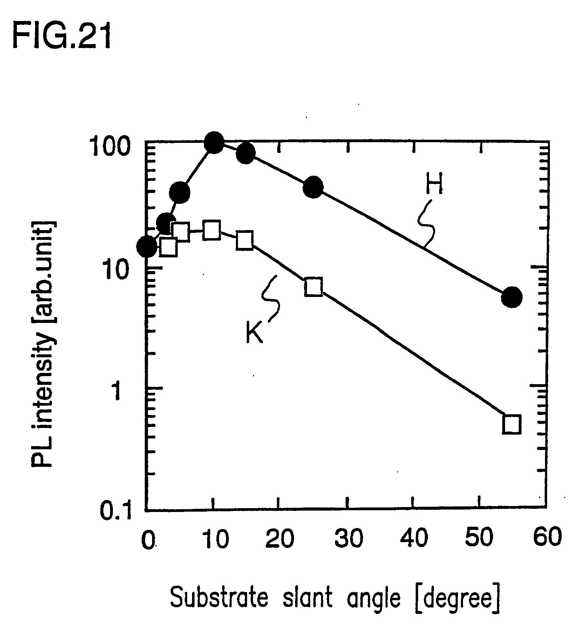

On the other hand, Figure 21 shows a measurement result of the photoluminescence emission intensity in the single quantum well formed of a multi-layered film produced in each of example 31 and comparative examples 11 and 12.

In the case of example 31 where a crystal was grown on a substrate slanted at an angle of 2° to 55° in [011] direction (A-direction), in a slant angle range from 2° to 25°, the emission intensity was increased as compared with a case where a non-slanted substrate (slant angle: 0°) was used; in the slant angle range of 25° or more (comparative example 11), the emission intensity was decreased. In the case of comparative example 12 where a crystal was grown on a substrate slanted in [011] direction (B-direction), in a slant angle range from 2° to 15°, the emission intensity was substantially equal or slightly increased as compared with a case where a non-slanted substrate was used; in the slant angle range of 15° or more, the emission intensity was decreased. In either slant direction, the emission intensity was increased in a relatively small slant angle range because the growth was performed in a step-flow mode. Further, when the slant angle is increased, a crystal surface deviates from a (100) face, and a step-flow growth in which crystal growth proceeds while keeping the crystal surface smooth cannot be achieved. Especially when a substrate slanted in [011] direction is used, it was found that there is a favorable slant angle range (2°-25°) within which both increase in the introduction efficiency of nitrogen into a film by a function of Al atoms at a step end and improvement in emission characteristic in a step-flow mode with improved efficiency of use of a nitrogen source material can be achieved.

In this example, a case where a substrate having, on its surface, crystal faces slanted at 2°, 5°, 10°, 15°, 25°, and 55° from a (100) surface in a [011] direction (A direction) has been described. However, it is needless to say that the same function/effect can be obtained when a substrate having on its surface a crystal face which is equivalent in a crystallographic sense to the above crystal faces is used. Further, although a crystal face slanted from a (100) surface in a [011] direction has been described, even with a slant direction deviated from [011] direction by about 10° in a direction parallel to a (100) surface, the same effects as obtained when a crystal face is slanted in a [011] direction can be obtained.

As described above, when a light emitting element is produced by forming a layered structure which is the same as that of example 11 on a crystal face slanted from a (100) surface in a [011] direction, a high-performance optical device which operates at a lower oscillation threshold current value can be produced.

### (Example 32)

In this example, a production example of an AlGaInNAs pseudo mixed crystal having a superlattice structure alternately including a single molecular layer of AlGaAsN and a single molecular layer of InGaAs.

Herein, crystal growth was performed on a GaAs (100) substrate at a substrate temperature of 550°C by a MBE method where solid sources were used as a III group source material and an arsenic source material, and a NH₃ gas source was used as a nitrogen source material. The grown crystal structure alternately includes 50 sets of a single molecular layer of Al_{0.2}Ga_{0.8}As_{0.96}N_{0.04} and a single molecular layer of Ga_{0.4}In_{0.6}As. The Al, Ga, In, and As₄ beam pressures during crystal growth were set to 7.0× 10⁻⁸ torr, 2.8×10⁻⁷ torr, 4.2×10⁻⁷ torr, 8.0×10⁻⁶ torr, respectively. The feed rate of NH₃, i.e., the beam pressure of NH₃, was set to 2.0×10⁻⁶ torr. In this case, the growth rate for AlGaAsN was one molecular layer per two seconds, and the growth rate for GaInAs was one molecular layer per one second. The above layered structure of a single molecular layer was grown such that molecular layers were formed in a one-molecular-layer by one-molecular-layer basis with one second intervals therebetween, whereby improvement in flatness of each molecular layer was achieved.

The PL (photoluminescence) emission wavelength of this layered structure at room temperature was about 1.3 µm, and the full width at half maximum for emission was 20 meV. That is, a very strong emission intensity was obtained.

### (Comparative Example 13)

For comparison, a bulk crystal of Al_{0.1}Ga_{0.6}In_{0.3}As_{0.98}N_{0.02} which is an average composition of a superlattice structure of AlGaAsN and GaInAs described in example 32 was formed. The Al, Ga, In, and As₄ beam pressures during crystal growth were set to 3.5×10⁻⁸ torr, 2.1 X 10⁻⁷ torr, 1.1 × 10⁻⁷ torr, and 8.0 × 10⁻⁶ torr, respectively. The growth rate was the same as in example 32. In this case, the feed rate of NH₃ required for obtaining a nitrogen-composition ratio of 0.02 was 5.0×10⁻⁶. That is, even though the nitrogen composition ratio was a half that of example 32, a 2.5 times larger NH₃ beam amount was required. The PL emission wavelength of this bulk crystal at room temperature was about 1.3 µm, which accords with the superlattice structure of example 32. However, the emission intensity was decreased to about 1/3.

Hereinafter, a function and an effect of the present invention are described with reference to example 32 and comparative examples 13.

As described in the above examples, the present inventors found that addition of Al improves the efficiency of use of NH₃ by two or more digits. Further, it was found that when In is added together, the efficiency of use of NH₃ is decreased to a fraction of that obtained when In is not included, i.e., In has a counter effect to that of Al. This example was conceived of for the purpose of avoiding an influence of reduction in efficiency of use of NH₃ when forming a mixed crystal in which In is added. That is, in this example, AlGaAsN, where nitrogen is crystallized in a mixed crystal while the efficiency of use of NH₃ is improved by adding Al and not adding In, and InGaAs, where In is included so that nitrogen is not crystallized in a mixed crystal, are superposed.

Thus, when growing a crystal of AlGaAsN, crystal growth can be performed while the efficiency of use of NH₃ is improved by Al. Therefore, an AlGaAsN layer with superior crystallinity can be grown. When growing an InGaAs portion, it is not necessary to crystallize nitrogen although In which decreases the efficiency of use of NH₃ is included. Therefore, an InGaAs layer with superior crystallinity can be grown. As a result, an AlGaAsN/InGaAs pseudo mixed crystal provides superior optical characteristics as compared with a bulk AlGaInNAs.

In example 32, an AlGaAsN/InGaAs pseudo mixed crystal has been exemplified, and a specific crystal growth method, emission characteristic, etc, thereof have been described. It is needless to say that a layer in which aluminum and nitrogen are included but indium is not included so that the efficiency of use of NH₃ is improved is not limited to an AlGaAsN layer. Such a layer may include any III or V group element, such as phosphorus (P), antimony (Sb), etc. Furthermore, it is also needless to say that a layer in which indium is included but nitrogen is not included is not limited to an InGaAs layer. Such a layer may include any III or V group element, such as aluminum (Al), phosphorus (P), antimony (Sb), etc.

Furthermore, the thickness of each of the layers which form a pseudo mixed crystal may be of any thickness as long as it includes one or more molecular layers. The number of molecular layers included in the pseudo mixed crystal need not necessarily be a natural number, but may be a fractional number, as long as it includes one or more molecular layers. However, if the thickness of each layer exceeds 10 molecular layers, each of the superposed molecular layers exhibits physical properties as an independent crystal, and therefore, the mixed crystal does not behaves as a pseudo mixed crystal. Thus, the thickness of each layer needs to be 10 molecular layers or less. It should be noted that after a layered structure described in this example has been formed, the layered structure may be subjected to a thermal treatment, an impurity diffusion process, or the like, so as to be disordered, whereby a substantially-uniform bulk crystal may be obtained.

### (Example 33)

A compound semiconductor layer or a compound semiconductor device produced according to the above-described examples was applied to a structure of an application system. Herein, as an example, an application of the production of an optical transmission/reception module used in an optical system is described.

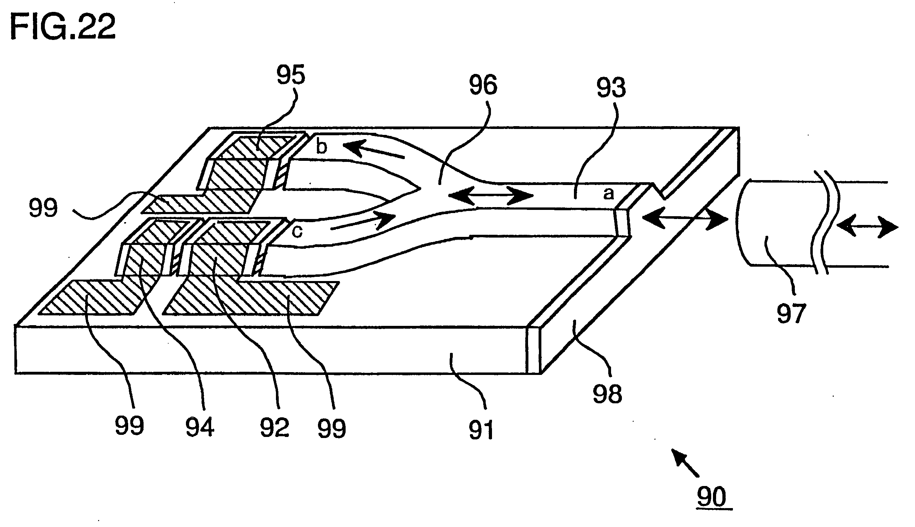

Figure **22** shows a schematic view of a produced optical transmission/reception module **90.** An optical signal having a wavelength of 1.3 µm transmitted from a base station through an optical fiber **97** is coupled to an optical waveguide **93** at point a and transmitted through the optical waveguide **93.** At a Y-branching section **96**, the optical signal transmitted is divided 50:50, one half reaches a detector section **95** for light-reception through point **b** and is converted into an electric signal. On the other hand, regarding a transmission function, an electric signal is converted to an optical signal by a semiconductor laser section **92**, and the optical signal is coupled to the optical waveguide **93** through point **c** and transmitted to the optical fiber **97** through point **a.** An output monitor section **94** monitors an optical output of a semiconductor laser from behind.

The semiconductor laser section 92 for transmission, the detector section **95** for light-reception, the output monitor section **94** of a semiconductor laser for transmission, and the optical waveguide **93** which form the optical transmission/reception module are formed by a single crystal growth operation, and these micro devices are monolithically integrated. The layered structures of the semiconductor laser section **92** for transmission, the detector section **95** for light-reception and the output monitor section **94** of a semiconductor laser for transmission are the same as that described in example 11. That is, in these layered structures, a semiconductor material containing aluminum in addition to arsenic and nitrogen is used in a core layer section of a quantum well active layer or a core layer so that the laser device provides a high performance. In the optical waveguide **93**, Zn is diffused into the waveguide **93** from the upper surface thereof so as to disorder the quantum well structure of the core layer, whereby the waveguide **93** becomes transparent to light having a wavelength of 1.3 µm. Each micro device is processed by dry etching so as to be separated from the other micro devices.

In this optical transmission/reception module, in the well layers of the semiconductor laser section **92** for transmission, the detector section **95** for light-reception, and the output monitor section **94** of a semiconductor laser for transmission, NH₃ is used as a nitrogen source material, and a semiconductor material containing arsenic and nitrogen is used. Furthermore, aluminum is included in the semiconductor material, whereby electric power consumed in a semiconductor laser section is reduced, and the light-electricity conversion efficiency is considerably improved in the detector/monitor section. Thus, performance of the entire system is improved.

In this example, NH₃ is used as a nitrogen source to grow a crystal of a semiconductor layer including arsenic and nitrogen together while adding aluminum, and the grown layer is used as a light emission layer, a light receiving layer, etc. On the other hand, it is needless to say that, even when a similar system is constructed by using various combinations of elements, compositions, orientations of a substrate, etc., which have been described above in the other examples, the constructed system also achieves high performance.

In the above, the application to an optical fiber transmission system has been described. However, it is needless to say that the same structure can be realized in an application system, such as a spatial light transmission system which does not use an optical fiber, an optical measurement system having a optical sensor function, a medical apparatus which uses a laser, etc., and the same effects can be obtained in such an application system.

It is needless to say that, the present invention is not limited to a specific crystal system, a combination of a composition of a mixed crystal, a band gap wavelength, or a hetero junction, or to a device structure described in the above examples. Specifically, a device is not limited to a semiconductor laser. The present invention can be applied to the formation of a certain layer of any optical device, such as a photodetector element, an optical waveguide element, etc., or any electronic device, such as a transistor, a FET, a HEMT, etc.

Furthermore, an application system is constructed by using the thus-produced semiconductor device, whereby performance of the application system can be considerably improved. Especially when such a device is used as an active layer of a semiconductor laser, high reliability, a low threshold current value and a reduction in characteristic deterioration during high-temperature operation can be realized. Thus, reduction of power consumption in an application system, such as an optical fiber transmission system, a spatial light transmission system, an optical measurement system, etc., is realized.

Furthermore, described in the examples of the present invention has been a case where several percentages of nitrogen is crystallized into a III-V compound semiconductor, and when Ga and In are suitably included in addition to Al as III group elements, As, P, and Sb are suitably included in addition to N as V group elements. However, other III group elements (B, T1, etc.) or a III group element (Bi) may be suitably crystallized into a crystal. Furthermore, the same effects can be obtained even when impurity elements (Zn, Be, Mg, Te, S, Se, Si, etc.) are suitably contained.

Furthermore, in the above examples, a GaAs substrate, an InP substrate, and a Si substrate are used. However, the substrates are not limited to these substrates. The same effects can be obtained by using other substrates. For example, other III-V compound semiconductor substrates such as an InGaAs substrate, II-VI compound semiconductor substrates such as a ZnSe substrate, and IV compound semiconductor substrates such as a Ge substrate and an SiC substrate, may be used.

Furthermore, the technique described in the present application can be applied to formation of a material where nitride is intentionally added as a part of its composition or as an impurity, or surface nitration of any material, such as introduction of an electron trap such as nitrogen into a GaP-based indirect transient material, doping of a II-VI semiconductor of ZnCdMgTeSSe with nitrogen, production of an amorphous material such as an SiN film, formation of a surface-nitrided buffer layer on a GaAs substrate for growing a cubic GaN-based material over the GaAs substrate, etc. These applications fall within the extent of the inventions of the present application.

In the above-described examples, as a crystal growth method, a MBE method, a CBE method, an MO-MBE method, and a GS-MBE method are used. However, each example is not limited to a crystal growth method described in the example, but may select a suitable one among the methods described in the other examples. Furthermore, although crystal growth in an ultra-high vacuum has been described in the examples in detail, the each example is not limited thereto. The technique of the present invention is applicable to a case where NH₃ gas is introduced by a vacuum deposition method, a vacuum sputtering method, a reduced pressure CVD method, or the like.

Furthermore, a source material of each component element used for crystal growth is not limited to the source materials specified in the examples or any specific combination thereof, but any material and any combination of materials may be employed. Especially, ammonium used as a nitrogen source material may be supplied in various forms, and the same effects can be obtained regardless of the form of ammonium. Vapor of liquid ammonium may be directly supplied to a substrate. Alternatively, ammonium diluted with hydrogen, nitrogen, argon, helium, other material gas, or a mix gas thereof, etc., may be supplied. Furthermore, ammonium may be mixed with other nitrogen compounds, such as a hydrazine system, an amine system, or the like, so long as much impurities are not introduced in a crystal.

Furthermore, it is effective to assist the decomposition of a nitrogen source material by cracking the nitrogen source material at an appropriate temperature or by applying UV light to the nitrogen source material. Furthermore, as a source material of aluminum, a molecular species which is obtained by subliming, evaporating, or sputtering any aluminum alloy, various organometallic compounds such as triethylaluminum (TEAl), dimethyl aluminum halide (DMeAlH), etc., or a mixture thereof may be used as well as aluminum metal and TMA1 which have been described in detail in the examples.

In the case where an organometallic compound is used as a source material, vapor thereof may be directly supplied to a substrate. Alternatively, the organometallic compound may be transported by using hydrogen, nitrogen, argon, helium, other material gas, or a mix gas thereof, etc., as a carrier. The degree of freedom in the selection of these source materials is the same for other source materials of gallium, indium, arsenic, phosphorus, antimony, etc.

It should be noted that in the above descriptions, a direction represented by "upper" denotes a direction which goes away from a substrate, and a direction represented by "lower" denotes a direction which comes close to the substrate. Crystal growth proceeds from a "lower" level to an "upper" level.

### INDUSTRIAL APPLICABILITY

According to the present invention, in crystal growth of a semiconductor material which is accompanied by addition/crystallization of nitrogen into a crystal or adsorption/substitution of nitrogen on a crystal surface, a crystal with high quality in which the residual impurity concentration and the etch pit density are low can be formed, and the efficiency of use of ammonium which is a nitrogen source material can be considerably improved.

Especially in the case where a III-V compound semiconductor including, as V group components, nitrogen and a V group element other than nitrogen is formed, a crystal having a superior emission characteristic can be formed while a sufficient amount of nitrogen is crystallized in the crystal. Thus, a crystal growth method of the present invention is suitable for producing a semiconductor laser which uses, in its active layer, a III-V compound semiconductor material including, as V group components, nitrogen and a V group element other than nitrogen. The crystal method of the present invention can produce a device which operates at a low oscillation threshold current value and which has a long lifetime. Furthermore, by constructing an application system using a compound semiconductor device produced according to the present invention, performance of the system can be improved. Especially when an optical transmission system or an optical measurement system is constructed by using a light emitting device produced according to the present invention, reduction of power consumption in the system and reduction in production cost of the system can be achieved.

Furthermore, based on the amount of added aluminum or based on whether or not aluminum is added, the amount of nitrogen introduced into a crystal can be controlled, and nitrogen can readily be added to only a portion of a substrate. By utilizing such a function, a semiconductor buried layer, an absorptive diffraction grating, a quantum wire, etc., can be formed through a vacuum continuous growth process, and a device having a superior device characteristic can be produced.

## Claims

1. A crystal growth method comprising a method for adding or crystallizing nitrogen in a crystal, wherein ammonium (NH₃) is used as a nitrogen source material, and aluminum is added.

2. A crystal growth method comprising a method for adsorbing a nitrogen atom on a crystal surface, wherein ammonium (NH₃) is used as a nitrogen source material, and the crystal surface includes aluminum.

3. A crystal growth method comprising a method for substituting a portion of elements in a crystal surface with nitrogen atoms, wherein ammonium (NH₃) is used as a nitrogen source material, and the crystal surface includes aluminum.

4. A crystal growth method according to any of claims 1-3,
wherein decomposition of ammonium and adsorption of nitrogen on a crystal surface is accelerated by aluminum.

5. A crystal growth method according to any of claims 1-4,
wherein the aluminum exists at least in an outermost surface of a growing layer.

6. A crystal growth method according to any of claims 1-5,
wherein an amount of nitrogen added to a crystal, a nitrogen composition, an amount of nitrogen adsorbed on a crystal surface and an amount of an element in the crystal surface which is substituted with a nitrogen atom are controlled based on an amount or composition ratio of added aluminum.

7. A crystal growth method according to any of claims 1-6,
wherein aluminum is added to or crystallized in a restricted region, whereby only in the restricted region, nitrogen is added or crystallized, a nitrogen atom is adsorbed, or an element in a crystal surface is substituted with a nitrogen atom.

8. A crystal growth method according to any of claims 1-7,
wherein a method selected among a molecular beam epitaxial (MBE) growth method, a metal organic molecular beam epitaxial (MO-MBE) growth method, a gas source molecular beam epitaxial (GS-MBE) growth method, and a chemical beam epitaxial (CBE) growth method is used.

9. A crystal growth method according to any of claims 1-8,
wherein crystal growth of a III-V compound semiconductor including, as V group components, nitrogen and a V group element other than nitrogen is performed.

10. A crystal growth method according to claim 9, wherein at least one of arsenic (As), phosphorus (P), and antimony (Sb) is selected as the V group element other than nitrogen.

11. A crystal growth method according to any of claims 9-10, wherein a substrate temperature is in a range from 450°C to 640°C.

12. A crystal growth method according to any of claims 2 and 4-11, comprising a series of steps including at least steps of:
supplying a III group source material including aluminum of less than one atomic layer;
subsequently, supplying ammonium so as to adsorb nitrogen atoms of less than one atomic layer; and
supplying a source material of a V group element other than nitrogen,
wherein the series of steps are repeated one time or more.

13. A crystal growth method according to claim 12,
wherein in the step of supplying ammonium so as to adsorb nitrogen of less than one atomic layer, the source material of the V group element other than nitrogen is not supplied at the same time.

14. A crystal growth method according to claim 12 or 13,
wherein crystal growth is performed over a single crystal substrate in which a {100} surface is a principal plane.

15. A crystal growth method according to any of claims 3-11, comprising a series of steps including at least steps of: forming a III-V compound crystal layer including at least one molecular layer of aluminum; and subsequently, supplying ammonium so as to substitute a portion of V group atoms in the III-V compound crystal layer with nitrogen atoms, wherein the series of steps are repeated one time or more.

16. A crystal growth method according to any of claims 3-11, comprising at least steps of:
crystal-forming a layered structure including at least a first semiconductor layer containing aluminum and a second semiconductor layer superposed thereon;
etching the layered structure while masking a portion of the layered structure such that the first semiconductor layer is exposed in a portion of an etched surface; and
supplying ammonium to the etched surface while heating the layered structure such that at least a portion of a constituent element in the first semiconductor layer is substituted with nitrogen.

17. A crystal growth method according to claim 16,
wherein the etched surface is a (n11)A surface (n=1, 2, 3,···).

18. A method for forming a semiconductor microwire structure wherein:
the crystal growth method of claim 16 or 17 is used when forming a semiconductor microstructure having a periodically-positioned wire pattern;
a diffraction grating is formed by the step of etching the layered structure while masking a portion of the layered structure such that the first semiconductor layer is exposed in a portion of an etched surface; and
a periodical wire structure is formed at a 1/2 of the pitch of the diffraction grating by the step of supplying ammonium to the etched surface while heating the layered structure such that at least a portion of a constituent element in the first semiconductor layer is substituted with nitrogen.

19. A method for forming a semiconductor microwire structure according to claim 18, wherein the wire structure is an absorptive diffraction grating section of a gain-coupled distributed feedback semiconductor laser having an absorptive diffraction grating, or a quantum wire.

20. A semiconductor device comprising a semiconductor layer formed by a crystal growth method described in any of claims 1-18.

21. A semiconductor device according to claim 20, wherein the semiconductor device is a light emitting element, and the semiconductor layer forms a light emitting layer thereof.

22. A crystal growth method according to any of claims 1-15, wherein a surface of the single crystal substrate is a crystal surface slanted from a (100) surface in a [011] direction (A direction) or a crystal face which is equivalent in a crystallographic sense to the slanted crystal surface.

23. A crystal growth method according to claim 22,
wherein the slant angle is within a range equal to 2° or more and equal to 25° or less.

24. A crystal growth method according to any of claims 1-15, wherein one or more pairs of semiconductor layer A and semiconductor layer B are superposed, the semiconductor layer A including at least Al and nitrogen in its composition but not including indium in its composition, and the semiconductor layer B including at least indium in its composition but not including nitrogen in its composition.

25. A crystal growth method according to claim 24,
wherein the thickness of each of the semiconductor layers A and B is one molecular layer or more, and ten molecular layers or less.

26. A semiconductor device comprising a semiconductor layer formed by the crystal growth method recited in any of claims 22-25.

27. A semiconductor device according to claim 26, wherein the semiconductor device is a light emitting element, and the semiconductor layer forms a light emitting layer thereof.

28. A system which uses a compound semiconductor device recited in any of claims 20, 21, 26, and 27.
